# EUROPEAN PATENT SPECIFICATION

(11) **EP 4 024 265 B1**
(45) Date of publication and mention of the grant of the patent: **24.04.2024**
(21) Application number: 21176328.9
(22) Date of filing: 27.05.2021
(51) Int. Cl.: G06G 7/26, G06G 7/06, G06G 7/625, G06F 30/34, G06F 30/36

(54) **PROGRAMMABLE ANALOG SIGNAL PROCESSING ARRAY FOR TIME-DISCRETE PROCESSING OF ANALOG SIGNALS**
PROGRAMMIERBARE ANALOGSIGNALVERARBEITUNGSANORDNUNG ZUR ZEITDISKRETEN VERARBEITUNG VON ANALOGSIGNALEN
RÉSEAU DE TRAITEMENT DE SIGNAL ANALOGIQUE PROGRAMMABLE POUR LE TRAITEMENT À TEMPS DISCRET DE SIGNAUX ANALOGIQUES

(30) Priority: 30.12.2020 EP 20217781
(43) Date of publication of application: 06.07.2022
(73) Proprietor: IHP GmbH - Innovations for High Performance Microelectronics / Leibniz-Institut für innovative Mikroelektronik, 15236 Frankfurt (Oder) (DE)
(72) Inventor: Kahmen, Gerhard, Frankfurt (Oder) (DE); Grass, Eckhard, Frankfurt (Oder) (DE)
(74) Representative: Eisenführ Speiser

(56) References cited:
- Anadigm: "AN231E04 Datasheet Rev 1.0", , 1 January 2007 (2007-01-01), pages 1-24, XP055857148, Retrieved from the Internet: URL:https://s1.dtsheet.com/store/data/0007 53195.pdf?key=9445b7d0a7177027759e5bd8b396 35c8&r=1 [retrieved on 2021-11-02]
- HU HAN-PING ET AL: "Design and Implementation of Autonomous and Non-Autonomous Time-Delay Chaotic System Based on Field Programmable Analog Array", ENTROPY, [Online] vol. 21, no. 5, 26 April 2019 (2019-04-26) , XP055857163, DOI: 10.3390/e21050437 Retrieved from the Internet: URL:https://www.mdpi.com/1099-4300/21/5/43 7> [retrieved on 2021-11-02]
- BRINK S. ET AL: "A Learning-Enabled Neuron Array IC Based Upon Transistor Channel Models of Biological Phenomena", IEEE TRANSACTIONS ON BIOMEDICAL CIRCUITS AND SYSTEMS, [Online] vol. 7, no. 1, 1 February 2013 (2013-02-01), pages 71-81, XP055857171, US ISSN: 1932-4545, DOI: 10.1109/TBCAS.2012.2197858 Retrieved from the Internet: URL:https://ieeexplore.ieee.org/ielx5/4156 126/6475288/06218734.pdf?tp=&arnumber=6218 734&isnumber=6475288&ref=aHR0cHM6Ly93d3cuZ 29vZ2xlLmNvbS8=> [retrieved on 2021-11-02]
- FALKOWSKI PIOTR ET AL: "Dynamically Programmable Analog Arrays in Acoustic Frequency Range Signal Processing", METROLOGY AND MEASUREMENT SYSTEMS, [Online] vol. 18, no. 1, 1 January 2011 (2011-01-01), pages 77-90, XP055857166, ISSN: 0860-8229, DOI: 10.2478/v10178-011-0008-1 Retrieved from the Internet: URL:https://journals.pan.pl/Content/89746/ PDF/Journal10178-VolumeXVIII%20Issue1_08%2 0paper.pdf.pdf> [retrieved on 2021-11-02]

## Description

### FIELD OF THE INVENTION

The present invention is in the field of signal processing of analog signals. It relates to a programmable analog signal processing array for processing incoming analog input voltage signals in accordance with a programmable signal processing function and for providing processed analog output voltage signals.

### BACKGROUND OF THE INVENTION

One typical application area of programmable analog signal processing arrays are analog signal processing units operated as Finite-Impulse Response (FIR) filter, Infinite-Impulse-Response (IIR) filter, and rank filter.

US 2010/0033228 A1 describes logic automata in the context of a reconfigurable statistical signal processing apparatus that comprises an array of discrete-time analog signal processing circuitry for statistical signal processing, based on a local message-passing algorithm and digital configuration circuitry for controlling the functional behavior of the array of analog circuitry. The signal processing apparatus serves for applications such as coding, decoding, and image processing, and employs features of analog logic in the context of a cellular automata architecture. Analog Logic Automata hardware provides a continuous-state, discrete-time computation model for modeling and solving digital signal processing problems by implementing local message-passing algorithms in a programmable fashion. The input signal to the apparatus is expressed as a probabilistic representation. The analog circuitry comprises computational elements arranged in a network, with a receiving module that assigns probability values when an input signal arrives and communicates the probability values to one of the computational elements, the computational elements producing outputs based on the assigned probability values. The signal processing apparatus of US 2010/0033228 A1 thus forms an array of analog logic automata cells, wherein each cell is able to communicate with all neighboring cells.

The publication "Anadigm : AN231E04 Datasheet Rev 1.0", 1 January 2007 (2007-01-01), describes an analog signal processor for signal conditioning, filtering, gain, rectification, summing, subtracting, and multiplying. The device accommodates sensor response linearization and arbitrary waveform synthesis. It consists of a 2x2 matrix of configurable analog blocks (CABs), surrounded by programmable interconnect resources and analog input/output cells with active elements. An on chip clock generator block controls clock domains generated from an external clock source. An internal band-gap reference generator is used to create temperature compensated reference voltage levels. Configuration data is stored in an on-chip SRAM configuration memory. An SPI like interface is provided for serial load of configuration data from a microprocessor or DSP.

### SUMMARY OF THE INVENTION

According to the present invention, a programmable analog signal processing array for programmable time-discrete processing of incoming analog input signals in accordance with a desired signal processing function and for providing processed analog output signals in accordance with the signal processing function is provided.

The processing array comprises a network of mutually interconnectable and pre-configurable analog processing slices that form unit circuit cells of the network and that each comprise a set of cell circuit elements. The cell circuit elements of the processing slices are:
- a switchable clock input port for receiving a clock signal;
- a delay element for receiving a respective analog slice input signal and for forwarding the received slice input signal with a pre-configurable time delay as a respective delayed slice input signal;
- an analog multiplier element receiving the delayed slice input signal, for providing an analog multiplier output signal corresponding to a product of the delayed slice input signal with a pre-configurable multiplication factor signal, and
- an analog adder element receiving a pre-configurable selection of at least two adder input signals including the multiplier output signal, for providing an analog adder output signal corresponding to a sum of the adder input signals; and
- an analog resample element for receiving the adder output signal and for providing the received adder output with a pre-configurable time delay as an analog slice output signal.

Thus, the programmable analog signal processing array of the present invention comprises a network of pre-configurable circuit blocks that provides a programmable in-memory-computing topology implementing a time-discrete analog signal processing approach. The circuit blocks of the network are herein referred to as processing slices. These processing slices of the network all have the described standard circuit structure in common. In other words, they all comprise the switchable clock input, the delay element, the analog multiplier element, the analog adder element and the analog resample element, and they all provide for the basic internal signal flow described above, from the reception of the analog slice input signal on the input side to the provision of the analog slice output signal on the output side of a given processing slice.

On top of this standard cell architecture and standard signal flow characteristics in the analog signal processing array, the individual processing slices provide a multitude of options for slice-individual, i.e., cell-by-cell pre-configuration. The configurability or programmability as used herein includes a re-configurability (re-programmability), i.e., the technical capability of allowing a change from a given configuration to another configuration. Pre-configurability means a capability to set a configuration before the desired signal processing function is to be performed based on a pre-programmed desired configuration. When describing processing slices, their circuit elements, or signal bus structures as pre-configurable herein, this is not meant to exclude, but include as an embodiment a dynamic configurability during operation of the programmable analog processing array in performing the desired signal processing function.

Thus, a programmable (including re-programmable) assignment of cell-individual signal-processing tasks to each processing slice in the overall signal flow of the signal processing for implementing a desired signal-processing function is enabled. Looking at the different options for pre-configuration in more detail, the clock input port is switchable and thus allows an on-off control of the feeding of a clock signal to the processing slice, be it fixed by programming or dynamic by control. Furthermore, the time delay induced by delay element of a given processing slice before providing the respective delayed slice input signal to the analog multiplier element is pre-configurable. This allows controlling the timing of the signal processing task performed by the given processing slice and forms the technical basis for implementing a time-discrete signal processing approach. Also, the multiplication factor, which is applied by the analog multiplier element to the delayed slice input signal is pre-configurable. Furthermore, a selection of zero, one or more adder input signals other than the multiplier output signal is pre-configurable. This enables the provision and processing of further adder input signals beyond the multiplier output signal, for providing an adder output signal having an amount that corresponds to the sum of the adder input signal amounts. Moreover, the provision of the cell-individual adder output signal with a with a pre-configurable time delay as the analog slice output signal provides further programmable timing options for controlling the signal flow between different processing slices.

For comparison, the known processing array of US 2010/0033228 A1 is based on logic cell automata as unit cells of the array. These include logic gates such as AND, OR, and XOR gates, which are implemented in an analog manner to allow determining a probability that a given input signal is "0" or "1", and to determine an output based on the respective logic function. As an example, an XOR gate of US 2010/0033228 A1 performs a mod2-addition function as known from digital logic gates, but in comparison pure digital logic gates tolerates input signals with a stronger variation in their signal amount. Thus, the processing array of US 2010/0033228 A1 can be described a "soft" digital processing array.

In contrast, the analog signal processing array of the present invention has unit circuit cells in the form of processing slices that comprise analog cell circuit elements, which perform a respective basic arithmetic operation to transform the respective analog slice input signals. As a specific example, the basic arithmetic operations include a multiplication of the (delayed) slice input signal with a pre-configurable factor signal. The signal transformation that is performed by the multiplier element to provide the analog multiplier output signal is a change in the signal amount, which corresponds to the product of the delayed analog slice input signal amount with a pre-configurable multiplication factor. Analog multipliers are frequently used for processing analog signals and form important circuit elements in many signal processing applications including filters, correlators, modulation detectors, and frequency converters. Analog multipliers are also used in forming signals with digital modulation.

Moreover, the analog adder element included in the processing slice performs an addition of the amounts of the analog adder input signals. Adder elements are also used in many signal processing applications, which for example include mixers that add waveforms together from various input channels.

As mentioned above, in contrast to the array of logic cell automata of US 2010/0033228 A1, the processing slices of the programmable analog signal processing array each provide a plurality of pre-configuration options, including, e.g., a pre-configurable selection of the multiplication factor, and a pre-configurable selection of adder input signals. A desired analog signal processing function can thus be implemented by suitable programming of the configuration of the network of processing slices and of its configurable temporal behavior, which includes proper cell-internal delay by the delay element and a suitable cell-output delay by the resample unit, which performs a track-and-hold function for stabilizing the slice output signal, and proper routing control of the signal flow between the different processing slices.

As will explained in more detail further below in the context of the description of embodiments of the signal processing array of the present invention, a further advantage of the described unique structure of the processing slices is that it allows achieving a defined switching back and forth between signals on a voltage plane and signals on a current plane within the given processing slice. By way of example, the analog multiplier element can be configured to switch from a voltage plane of the delayed slice input signal to a current plane of the multiplier output signal, and the analog resample element can be configured to switch from a current plane at an output of the analog adder element back to a voltage plane, such that the analog slice output signal is on the same voltage plane as the slice input signal. This way, a freely configurable interconnectability of the processing slices among each other all over the analog fabric formed by the network of processing slices is ensured.

In comparison with digital programmable processing arrays such as field programmable gate arrays, the analog signal processing array of the present invention achieves the advantage that no increase of hardware expenditure is required for achieving a higher signal resolution because the received signals are processed in the analog domain. Furthermore, the programmable analog signal processing array implements an in-memory-computing approach in that data to be processed are represented by analog signals that are routed according to a programmed signal processing flow and need not be stored in a memory and read before processing.

Preferred embodiments of the analog signal processing array further comprise a pre-configurable analog signal bus for receiving and providing the analog input signals to the network of processing slices and for interconnecting any given processing slice to one or more respective other of the processing slices of the network of processing slices to transport the slice input signals and slice output signals. The signal communication within the network of processing slices during the signal processing operation is thus based on a bus infrastructure. Throughout the present specification and in the claims, the term "bus" is used to denote a means of signal communication between two or more processing slices. As such, a bus forms an electrical interconnect system that can be implemented in different forms. In its simplest form, a bus can be formed by a point-to-point signal connection between two processing slices. In preferred, more complex embodiments, a bus comprises a configurable network of electrical interconnect segments that can be interconnected by means of a switching infrastructure according to a pre-configurable bus configuration. The pre-configurable analog signal bus in the form of such a pre-configurable network of interconnects between processing slices allows implementing any desired connections between processing slices as well as blocking undesired connections between processing slices, in accordance with a programmable configuration that serves to implement the desired signal processing function. The analog signal bus of some embodiments provides interconnections between processing slices to form one or more meshed signal interconnect networks.

The analog signal bus of some embodiments suitably comprises different bus components, including
- a first signal bus, hereinafter analog in-out bus, for receiving the slice input signals and routing them to a pre-configurable set of processing slices and for receiving the slice output signals of the processing slices in accordance with the signal-bus configuration;
- a second signal bus, hereinafter multiplier bus, for receiving the respective delayed slice input signals and routing them to a pre-configurable set of processing slices in accordance with the signal-bus configuration;
- a third signal bus, hereinafter adder bus, for receiving the respective multiplier output signals and routing them to a controllable set of processing slices in accordance with the signal-bus configuration;
- a fourth signal bus, hereinafter adder output bus, for receiving the respective adder output signals and routing them to a pre-configurable set of resample elements in accordance with the signal-bus configuration.

The analog in-out bus, the multiplier bus, the adder bus and the adder output bus are each switchably interconnectable with each of the processing slices in accordance with the signal-bus configuration. Analog signals transported on any one of the bus components of the analog signal bus for performing the desired signal processing function are herein also summarized under the generic term analog data signals. Thus, this includes the slice input signals, slice output signals, delayed slice input signals, multiplication factor signals, multiplier output signals, adder input signals, and the adder output signals.

Preferred embodiments additionally comprise a configuration-signal bus for receiving and routing respective configuration control signals to the individual processing slices, wherein the respective configuration control signals are for configuring
- individual time delays of the respective delay elements,
- individual multiplication factors of the respective multiplier elements,
- individual selections of adder input signals to the respective adder elements, and
- individual switchable interconnections of the respective processing slices to the analog signal bus for routing, in accordance with a programmable signal-bus configuration and with the signal processing function, the input signals, the respective slice input signals, and the respective slice output signals between the processing slices via the analog signal bus;
   and, connected to the network of processing slices,
- individual switching states of the clock input ports for allowing or blocking the provision of the clock signal to the respective processing slice.

Such embodiments suitable comprise in addition a configuration control unit for receiving a configuration code and for using the configuration code to generate the configuration control signals to configure the network of processing slices for implementing an analog signal processing circuit that in operation performs the desired signal processing function.

Thus, the configuration control unit uses the received configuration code to build the analog signal processing circuit from the "raw" building blocks provided by the programmable analog signal processing array. The configuration control signals are generated and provided to the processing slices including their switchable interconnections to the analog signal bus in a suitable form to set, or, in other words, program the respective configuration for implementing the desired signal processing circuit into the analog signal processing array.

This configuration scheme for the analog signal processing array of the present embodiment forms a "digital-like design flow" and is thus easy to use for the circuit designer. Digital design flows combine well known automation tools in the design of an integrated circuit, which involve, among others, synthesis, placement and routing algorithms.

The following turns to the advantageous capability of embodiments of the processing slices to allow switching back and forth between a voltage plane and a current plane. In some embodiments, the delay element of the programmable analog signal processing array is configured to receive the respective analog slice input signal as a first analog voltage signal and to provide the respective delayed slice input signal as a second analog voltage signal. Moreover, the analog multiplier element is configured to provide the analog multiplier output signal as a first analog current signal, and the analog adder element is configured to receive the at least two adder input signals as analog current signals and to provide the analog adder output signal also as an analog current signal of an amount indicative of the sum of the adder input signals. Furthermore, in such embodiments, the resampling element suitably comprises a current-to-voltage converter for receiving the analog adder output signal and for providing an adder output voltage signal of an output voltage amount indicative of the current amount of the analog adder output signal as the slice output signal. This embodiment achieves that a voltage plane of the slice output voltage signal of the current-to-voltage converter is the same as that of the slice input signal received by the delay element. This embodiment ensures a freely configurable interconnectability of the processing slices among each other.

However, to achieve such freely configurable interconnectability of the processing slices, it is not a requirement to use exactly the structure of the corresponding embodiments described. It is a requirement only, that the output of the resample element is of the same signal type as the slice input signal. Other processing slice designs can be suitable to achieve this. For instance, the analog adder element may provide the adder output signal in the form of a voltage signal and not of a current signal. In this case, the resample element does not need to perform current-to-voltage conversion for providing the slice output signal. In another variant, the multiplier element may provide the multiplier output signal in the form of a voltage signal and not of a current signal, and the analog adder element may thus be configured to add received input voltage signals.

Another embodiment of the analog signal processing array further comprises a configuration input port for receiving hardware configuration data defining, using e.g. a hardware description language, a structure and behavior of an analog signal processing circuit performing a signal processing function to be implemented by the programmable analog signal processing array. Furthermore, this embodiment comprises a configuration processor for transforming the hardware description data into net list data indicative of a net list of processing slices and for transforming the net list data into place-and-route data indicative of place-and-route information to be implemented using the network of processing slices and determining desired interconnections of the processing slices that implement the analog signal processing circuit, and for transforming the net list and the place-and-route data into the configuration code. The configuration code thus represents topological data that specifies the topology of the signal processing circuit to be implemented by the programming of the analog signal processing array.

This embodiment advantageously enables a programming of the analog signal processing array in the same manner as it is known from field programmable gate arrays in the digital domain and thus allows making use of well-implemented and advanced design procedures, which facilitates an easy integration of the advantageous performance of the programmable analog signal array into existing digital data and signal processing design workflows, without requiring the designer to learn new design methodologies.

This embodiment is particularly suited for use in further developed embodiments that include an arrangement of digital and analog processing arrays, and thus integrate a digital part including a field programmable gate array with an analog part that includes an analog signal processing array according to the present embodiment. The inclusion of a digital part with a field programmable gate array enables an integration of "classical" digital processing slices such as look-up tables, digital adders, digital multipliers, serializer-deserializer (Ser-Des) elements and others with the in-memory-computing topology that is provided by the programmable analog signal processing array. A change between the analog domain of the analog signal processing array and the digital domain of the digital field programmable array can be achieved by routing the respective analog or digital signals via analog-to-digital converters or digital-to-analog converters where necessary.

Analog circuit elements and processing slices may vary in their signal processing characteristics even if they are nominally identical. Preferred embodiments mitigate this issue by using a further developed configuration processor that is further configured to generate, using the hardware description data, desired slice response data that is indicative of individual desired delayed slice input signals of the respective cell circuit elements of the individual processing slices in response to one or more predetermined analog configuration test signals. In a variant of this embodiment, it is not the configuration processor that generates the slice response data, but a different processor, which is referred to as configuration test processor, and the configuration processor forwards the received hardware description data to the configuration test processor. In another variant, the hardware description data is directly provided to the configuration test processor, via a data connection that is parallel to that feeding the configuration processor with the hardware description data.

These embodiments additionally comprise an analog test bus, which is connected with the configuration control unit and which is connectable with the individual processing slices to provide them with the one or more analog configuration test signals generated by the configuration control unit and to provide the configuration control unit with respective individual slice test-response signals provided by the respective cell circuit elements of the processing slices, each in response to the one or more configuration test signals.

The configuration control unit is suitably configured to generate the one or more predetermined configuration test signals and to determine deviations of the received slice test-response signals from the desired slice response data in accordance with predetermined deviation criteria, and in case of determining a deviation for a given processing slice, to generate the adapted configuration data for the respective processing slice and use the adapted configuration data for providing one or more adapted configuration signals to the respective processing slice. In a variant, the configuration processor is additionally configured to add the adapted configuration data to the configuration code, for instance in the form of calibration data that represent corrections to be applied to nominal circuit-element configuration data. For instance, weight factor corrections may be applied to individual analog multiplier elements due to determined deviations from nominal weight factor values, caused, e.g., by production inaccuracies or fluctuations.

Another embodiment of the programmable analog processing array further comprises a configuration memory for storing the net list, the place-and-route data, the configuration code, the configuration data and, if provided, the adapted configuration data. Such adapted configuration data can be determined and stored in a calibration routine during production of the programmable analog signal processing array. In contrast to configuration data representing static topological data, adaptable configuration data may also be determined by the configuration control unit or the configuration processor by performing a background calibration process while the analog signal processing array is otherwise operative in performing the signal processing function.

The configuration control unit is thus configured to use the configuration code for generating respective configuration signals that establish desired electrical connections between the processing slices. Suitably, processing slices may have associated control elements that receive configuration signals associated with the processing slices from the configuration control unit for controlling a routing of
- the configuration signals to the respective processing slices;
- the configuration test signals associated with the processing slices and the slice test-response signals in response to the configuration test signals from the processing slices via the analog test bus,
- the clock signal to the respective processing slices; and of
- analog data signals between the processing elements of the processing slices via the analog signal bus.

The control elements can be implemented as control registers or look-up tables receiving and storing suitable configuration signal information in digital form from the configuration control unit and feeding the corresponding configuration signals to the respective switching elements and circuit elements of the processing slices. If required, e.g. when configuring the multiplication factors or calibration weighting factors, a DAC or other suitable transformation element can be used to generate the configuration signals from the stored configuration signal information.

The following turns to embodiments having different implementations of the analog multiplier element. In one embodiment, the multiplier element of the processing slices comprises a configurable memristor, which receives the delayed slice input signal and which is configured to provide the multiplier output signal as a current signal of a current amount that is indicative of a product of an input voltage amount of the delayed slice input signal multiplied by the received multiplication factor signal. The configurability refers to the determination of a weight factor to be applied in the multiplication. The use of a memristor in an analog multiplier element is per se known. The configuration of the multiplication factor effected by the memristor is achieved using a configuration signal provided to the memristor. The configuration signal causes a change in a state variable of the memristor. The change in the state variable of the memristive device results in the output of a product of the input signal with the configured multiplication factor.

In a further development of this embodiment, the configuration control unit is configured to use the configuration input data or, if present, the adapted configuration data to determine respective memristor configuration signal amounts to be applied to the respective memristor of the multiplier elements of the individual processing slices to set or adapt a respective multiplication factor of the respective multiplier element, and to subject the respective memristor of the multiplier elements to the determined configuration signal of the determined configuration signal amount.

Depending on the particular implementation of the memristor, the configuration signal can be a current or a voltage. Other physical quantities, however, may also be useable for implementing the configuration signal.

The multiplication factor of an analog multiplier element using a memristor may be subject to undesired variation over the course of analog signal processing operation. To compensate for undesired variations in the signal processing, a background calibration of the memristors is provided in a further embodiment. In this embodiment, the configuration control unit is configured
- to switch to an intermittent background calibration mode under a signal processing operation of the processing array, and, in the background calibration mode,
- to generate and provide via the analog test bus one or more multiplier test signals to the multiplier elements,
- to determine from the received multiplier output signals a deviation of a respective multiplication factors from the respective desired multiplication factors according to the configuration code; and, in case of a determining a deviation,
- to generate and provide a respective memristor re-configuration signal amount to be applied to the respective memristor of the multiplier elements of the individual processing slices in order to re-set the respective multiplication factor of the respective multiplier element to the desired value; and
- to subject the respective memristor of the multiplier elements to the determined respective reconfiguration signal amount.

In alternative embodiments of the processing slice the multiplier element of the processing slices comprises a field effect transistor (FET) as the active component instead of a memristor. If operated in a linear range at a suitably low drain-source voltage, the FET represents a controllable resistive element that can be controlled via a control voltage to be applied to its gate electrode.

A control voltage determining the multiplication factor is applied to the gate electrode of the FET. In operation, for example, the FET receives an input voltage signal of the delayed slice input signal at the source electrode, and provides an output current signal corresponding in its amount to the a mount of a product of the input voltage signal and the configured multiplication factor. The drain electrode is suitably connected to the current bus to provide the output current signal. Here, thus, the configurability refers to the selection of the multiplication factor entering in the multiplication by suitably controlling the voltage applied to the gate electrode of the FET.

In a further development of this embodiment, the configuration control unit is configured to use the configuration input data or, if present, the adapted configuration data to determine respective FET configuration signal amounts to be applied to the gate electrode of a given FET of the multiplier elements of the individual processing slices to set or adapt a respective multiplication factor to be applied by the respective multiplier element, and to apply the determined configuration signal of the determined configuration signal amount during signal processing operation. The determined signal can be applied by storing a digital representation of the configuration signal in a configuration register or configuration register area associated with the multiplier element, and feeding it to the respective multiplier element via a DAC.

In other embodiments, the analog multiplier is implemented as an analog multiplier circuit known per se, which receives the delayed slice input signal and is configured to provide as an output a product of the delayed slice input signal with a multiplication factor that is prestored in digital form in a register and fed to the multiplier circuit via a digital-to-analog converter. For instance, analog multiplier topologies such as those known from a Gilbert cell are suitable for use in a processing slice.

In some embodiments, the network of processing slices is partly or completely divided into identical macrocells that each comprise a plurality of processing slices. Macrocells may have a different granularity in different embodiments. A particularly small macrocell may be made of only two processing slices. In other embodiments, a macrocells comprises up to ten, up to 50, or up to 100 processing slices.

To enable a programmable configuration of the macrocells, the configuration control unit is configured to use the configuration code for generating respective configuration signals that establish desired electrical connections between the processing slices of a given macrocell. Each of the macrocells has an associated control element that receives the configuration signals associated with the processing slices of the given macrocell from the configuration control unit for controlling a routing of
- the configuration signals to the respective processing slices of the given macrocell,
- the configuration test signals associated with the processing slices of the given macrocell and the slice test-response signals in response to the configuration test signals from the processing slices of the given macrocell via the analog test bus,
- the clock signal to the respective processing slices of the given macrocell; and/or of
- analog data signals between the processing elements of the processing slices via the analog signal bus.

The time-discrete computing approach can be implemented in different ways. One group of embodiments of the programmable analog signal processing array comprises a clock generation unit that is configured to generate a pair of two-phase non-overlapping clock signal trains to the processing slices via the clock bus. In this group of embodiments, one way of implementing the pre-configurable delay element of the processing slices involves a series of at least two switching elements that receives the slice input signal. Each of the switching elements also has a control gate receiving a respective one of the clock signal trains for opening and closing the switching element in accordance with the two phases of the respective clock signal train. The delay element further comprises parallel capacitances respectively arranged, in a direction of signal flow, behind each switching element, for providing the delayed slice input signal behind the last switching element in the direction of signal flow.

In a variant under this group of embodiments, only a single two-phase clock signal train is generated originally, and a suitable separate circuit, which is per se known, receives this clock signal train and uses it to generate the second, clock signal train in a non-overlapping manner with the first train. One example of this variant uses an inverter upstream of the control gate of the second switching element to generate the second clock signal train.

A second group of embodiments involves an operation of the entire array of processing slices with asynchronous handshake signals, e.g., using a 4-phase handshake without any clock signal. This reduces or fully avoids unwanted influences of the clock signal on the analog signal values, for instance capacitive couplings, or dips of the operating voltage. In this second group of embodiments, the analog signal bus is associated with and controlled by at least one handshake line for transporting communication control signals between the processing slices in accordance with a handshake protocol. The processing slices or, if present, macro cells each further comprise an associated handshake circuit which is configured to
- generate and provide communication control signals on behalf of the respective associated processing slice or macrocell for asynchronous communication with other processing slices or macro cells of the network of processing slices or macro cells in accordance with a handshake protocol;
- control the time delay in providing the delayed slice input signal by the delay element, and to
- control a timing of an output of the multiplier output signal, or of the adder output signal via the signal bus in response to a protocol exchange with at least one target processing slice in accordance with the handshake protocol.

Further embodiments will be presented in the context of the following description of the enclosed drawings.

### BRIEF DESCRIPTION OF THE DRAWINGS

### In the drawings:

Fig. 1 is a block diagram illustrating a high-level structure of a programmable analog signal processing array according to an embodiment of the present invention;
Fig. 2 is a block diagram of a processing slice that forms an elementary circuit cell of a programmable analog signal processing array according to an embodiment of the present invention;
Fig. 3 is a block diagram of an exemplary programmable macrocell of processing slices for use in an analog processing array of the type shown in Fig. 1;
Fig. 4 is a block diagram illustrating a high-level structure of a programmable analog signal processing array 400 according to a further embodiment of the present invention;
Fig. 5 is a diagram illustrating the configurability of access control between the processing slice of Fig. 2 and an analog test bus;
Fig. 6 is a simplified circuit diagram of a section of an analog processing array, the section showing two processing slices;
Fig. 7 is a circuit diagram of a delay element and an analog multiplier element suitable for use in a processing slice of a programmable signal processing array of the present invention;
Figs. 8 to 10 show an alternative implementation of an analog multiplier element in the form of a field effect transistor;
Fig. 11 shows a circuit diagram of an exemplary analog adder element suitable for use in a processing slice;
Fig. 12 shows a circuit diagram of another exemplary adder element suitable for use in a processing slice;
Fig. 13 is a circuit diagram of another exemplary analog multiplier element for use in a processing slice;
Fig. 14 is a circuit diagram of another exemplary analog multiplier element for use in a processing slice;
Fig. 15 is a schematic illustration of a another embodiment of a processing slice that uses a true-time delay element; and
Fig. 16 is an illustration of a further implementation of a controllable delay element that uses a handshake concept in the signal communication between processing slices.

### DETAILED DESCRIPTION OF EMBODIMENTS

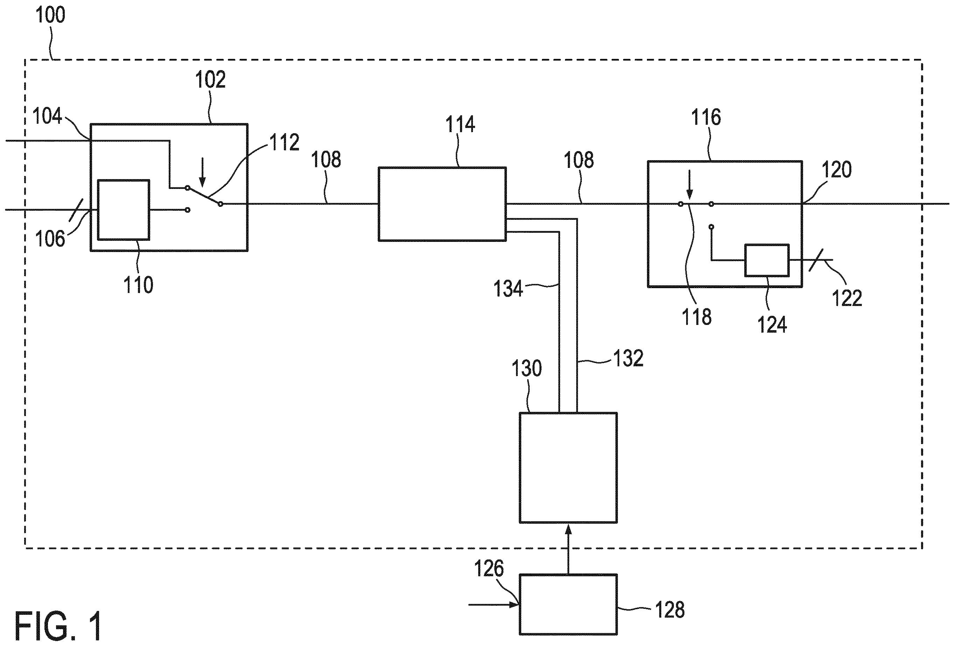

Fig. 1 is a block diagram illustrating a high-level structure of a programmable analog signal processing array 100 according to an embodiment of the present invention. The programmable analog signal processing array will hereinafter also be referred to in short as PASPA.

The PASPA 100 comprises in an input unit 102 with an analog signal input port 104 and a digital signal input port 106. The analog signal input port 104 is configured for receiving analog input signals. In different variants of the present embodiment, the input port is configured to receive one or more analog input signals in parallel. Depending on a bus width of an analog signal bus that forwards the analog input signals received in parallel by the analog signal input port 104, the analog signal input port 104 may distribute the received analog input signals directly to the bus lines, or via one or more multiplexer (not shown). In the present embodiment, the analog input signals are analog voltage input signals. In other embodiments, the analog signal input port 104 receives analog current input signals and comprises a current-to-voltage converter (not shown), for instance including a transim-pedance amplifier.

In the present embodiment, the input unit 102 additionally comprises the digital signal input port 102, which is configured to receive signal words with a plurality of bits in parallel. The digital signal input port further comprises a digital-to-analog converter (DAC) 110 which receives the incoming digital signal words and converts them to analog voltage signals of an amount corresponding to that indicated by the received signal word and provides them to the analog signal bus 108. A controllable switch 112 serves to select one from the analog and digital signal input ports 104 and 106 for feeding the received input signals to the analog signal bus 108 at a given point in time. Details of the control structure for providing a suitable time-dependent control signal to the switch 112 are not shown here.

It should be noted that the provision of a digital signal input port 106 is an optional feature that increases the versatility of the PASPA 100 by adding an option of receiving and processing digital input signals. However, other, simpler embodiments only have the analog signal input port 104 and no digital signal input port.

The analog signal bus 108 forwards the received input signals in analog form to an analog processing array 114. The analog signal bus 108 can be compared to a data bus that transports the data to be processed

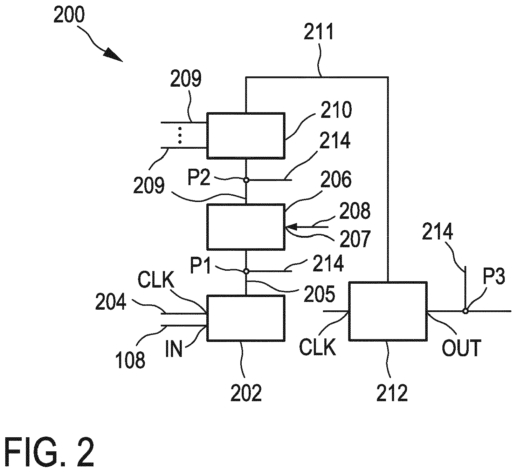

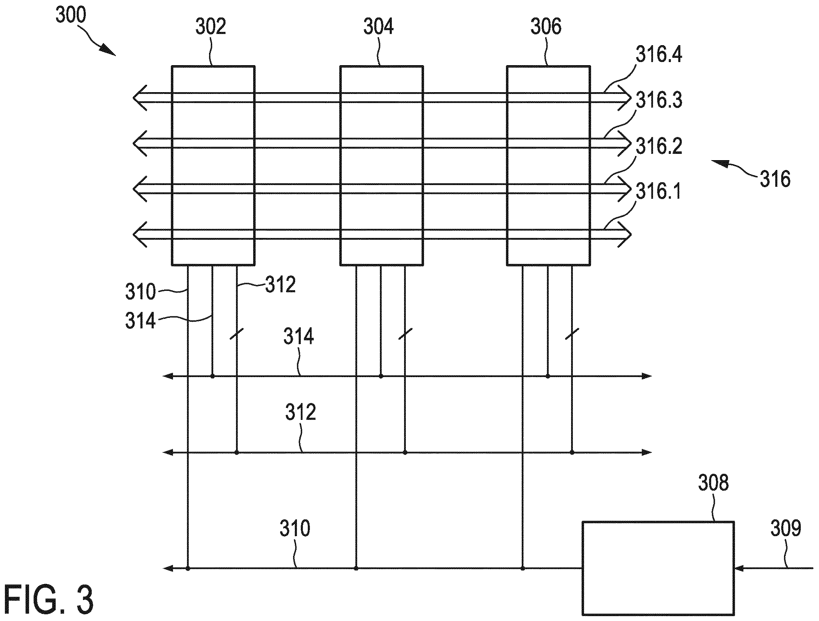

The analog processing array 114 is made of a network of mutually interconnectable and pre-configurable or, in other words, programmable analog unit circuit cells, which herein are referred to as processing slices. The number of processing slices depends on the desired signal processing capacity and typically exceeds ten thousand processing slices. In embodiments with higher signal processing capacity, the number of processing slices exceeds fifty thousand, one hundred thousand, or even one million processing slices. The network of progammably interconnectable processing slices can also be described as an analog processing fabric. Details of the structure of the analog processing array 114 will be described further below with reference to the embodiments shown in Figs. 2 and 3.

Output of the analog output signals of the analog processing array 114 is provided via an output unit 116 that comprises a controllable output selection switch 118, which selects between an analog output via analog output port 120, or a digital output via a conversion by analog-digital converter 124 and a digital output port 122.

A configuration processor 128 that is external to the analog signal processing array 100 comprises a configuration input port 126 for receiving hardware description data defining, using a hardware description language, a structure and behavior of an analog signal processing circuit performing a signal processing function and to be implemented by the programmable analog signal processing array 100. The configuration processor 128 is provided for transforming the hardware description data into net list data indicative of a net list of processing slices and for transforming the net list data into place-and-route data indicative of place-and-route information to be implemented using the network of processing slices and determining desired interconnections of the processing slices that implement the analog signal processing circuit, and for transforming the net list and the place-and-route data into configuration code. The configuration code thus represents topological data that specifies the topology of the signal processing circuit to be implemented by the programming of the analog signal processing array.

The programmable signal processing array 100 comprises a configuration control unit 130 for receiving the configuration code from the external configuration processor 128 and for using the received configuration code to generate configuration control signals and provide them to the signal processing array 114 via a control bus 132 to configure the network of processing slices of the analog processing array 114 for implementing an analog signal processing circuit that in operation performs the desired signal processing function. The configuration control signals are provided to the processing slices including their switchable interconnections to the analog signal bus in a suitable form to program the respective configuration for implementing the desired signal processing circuit into the analog signal processing array. This process is generally known from the configuration and programming (sometimes in colloquial terms described as "burning") of digital processing circuits in FPGAs. A suitable current or voltage amount can be used to configure a given circuit property, depending on the particular hardware implementation. This configuration scheme for the analog signal processing array can be described as a "digital-like design flow". For the circuit designer, no substantial deviation from his or her design process is required, and use of well-known automation tools in the design of an integrated circuit using an FPGA can be expanded correspondingly to program the analog processing array 114.

Furthermore, an analog test bus 134 connects the configuration control unit 132 with the signal processing array 114 to feed analog configuration test signals generated by the configuration control unit 130 and to provide the configuration control unit 130 with respective individual test-response signals provided by the respective cell circuit elements of the processing slices of the signal processing array 114 in response to the configuration test signals. This will be explained in more detail in the context of the embodiment of Fig. 2.

Embodiments of the PASPA 100 are implemented as a single integrated-circuit package. Other embodiments are implemented by means of a circuit board that comprises different integrated circuit packages connected to form the PASPA.

Variants of embodiment of Fig. 1 comprise the configuration processor 128 as an internal unit of the PASPA 100, for instance as a separate processor chip on a circuit board shared with a chip of the configuration control unit 130, and, optionally, also shared with the analog signal processing array 114 and its periphery, in particular the input unit 102 and the output unit 116.

For a closer look at the structure of the individual processing slices of the analog processing array 114, additional reference is now made to Fig. 2. Fig. 2 is a block diagram of a processing slice 200 that forms a unit circuit cell or standard cell of the analog processing array 114 according to an embodiment of the present invention. Typically, all processing slices comprise the same set of cell circuit elements, which are shown in Fig. 2. However, other embodiments have more than one type of processing slices.

A first cell circuit element of the processing slice 200 is a pre-configurable delay element 202. It has a switchable clock input port CLK for receiving a clock signal via a clock bus 204 (not shown in Fig. 1). For reasons of graphical simplification, a controllable switch for on-off control of the feeding of the clock signal via the clock input port CLK is not shown in Fig. 2. Also, an array-internal control bus connected to the control bus 132 for providing the control signal to the controllable switch is not shown here. Beside the clock signal, the delay element 202 further receives an analog slice input signal from an analog signal bus 108 via a slice signal input port IN. Depending on the pre-configured routing of signals, the slice input signal may be one of the input signals received by the input unit 102, or an analog slice output signal provided by another processing slice.

The delay element 202 is configured to provide a delayed slice input signal that, except for the imposed delay, otherwise corresponds to the received slice input signal. An amount of the delay of the delayed slice input signal in comparison with the received slice input signal is pre-configurable. It can be controlled by means of the on-off control of the clock signal received at the clock input port CLK. Imposing a delay of a pre-configured amount in terms of a single clock period or multiples of a clock period supports a time-discrete signal processing scheme. Details of different implementations of the delay element 202 will be shown further below.

A multiplier bus 205 connects the delay element 202 with a second cell circuit element of the processing slice 200, which is an analog multiplier element 206. In the present embodiment, the analog multiplier element 206 has a multiplier configuration input 207 that is connected to the array-internal section of the control bus 208 for setting a pre-configurable multiplication factor that enters the signal multiplication performed by the multiplier element 206.The analog multiplier element 206 receives the delayed slice input signal and is configured to provide an analog multiplier output signal corresponding to a product of the delayed slice input signal and the pre-configurable multiplication factor. The multiplication factor is received via the multiplier configuration input 207. The function of an analog multiplier element is per se known in the art. Depending on the specific implementation of the multiplier element 206, the multiplier output signal is an analog current signal or an analog voltage signal. Exemplary implementations of analog multiplier elements will be described further below.

An adder bus 209 connects the output of the multiplier element 206 with one input of an analog adder element 210, which forms a third circuit element of the processing slice 200. The analog adder element 210 receives a pre-configurable selection of at least two adder input signals via a corresponding number of different signal lines of the adder bus 209. Thus, at least one of the signal lines of the adder bus 209 carries the multiplier output signal of the multiplier element 206 as one of the adder input signals. The other signal lines of the adder bus 209 are available for providing adder input signals generated by different processing slices, as required for performing a desired signal processing function. The analog adder element 210 is configured to provide an analog adder output signal that corresponds to a sum of the received adder input signals. An exemplary implementation of an adder element 210 will be presented further below. Depending on the implementation of the adder element 210, the adder output signal is an analog current signal or an analog voltage signal.

Finally, an analog resample element 212 is provided as a fourth circuit element of the processing slice 200. It receives the adder output signal via a resampler bus 211, and a clock signal, and provides the received adder output signal with a pre-configurable time delay as an analog slice output signal of the processing slice 200 at a slice signal output port OUT.

To facilitate networked processing involving a sequence of processing steps performed by a plurality of interconnected processing slices, the analog slice output signal provided at the slice signal output port OUT is suitably provided in the form of a physical quantity that is the same as that of the slice input signal received at the slice signal input port IN. In present embodiment, for instance, if the analog input signal is received as an analog voltage signal at the slice signal input port IN, the slice output signal is provided by the resample element 212 at the slice signal output port OUT as an analog voltage signal as well. As an example, in case the adder output signal is an analog current signal, the resample element 212 is configured to convert the incoming adder output signal to a voltage signal having a voltage amplitude indicative of the current amplitude of the adder output signal, and having the pre-configurable time delay. Three test access points P1, P2 and P3 allow access to respective an array-internal section of an analog test bus 214 that serves to feed analog configuration test signals generated by the configuration control unit 130 (cf. Fig. 1) and to provide the configuration control unit 130 with respective individual slice test-response signals provided by the respective cell circuit elements of the processing slice in response to the configuration test signals. As an example of the use of the analog test bus 134, 214 and the test access points, a configuration test signal can be fed to the analog multiplier element 206 via the array-external and array-internal analog test bus sections 134, 214 to access point P1, suitably in a test phase outside actual operation of the signal processing function, along with a pre-determined multiplication factor that is provided to the multiplier element 206 via multiplier configuration input 207. A multiplier test output signal can then be picked up via access point P2, fed back to the configuration control unit 130 and evaluated. The evaluation by the configuration control unit 130 determines whether the factor currently applied by the analog multiplier element 206 is correct for performing the desired multiplication in the context of the signal processing function. A correct functioning of the analog adder element 210 and the analog resample element 212 can be determined in a similar manner.

The analog test bus is structured to allow an individual addressing of each of the test access points in each of the processing slices. Fig. 2 does not show switching elements that control an access state of the test access points P1 to P3 (open/closed, feeding/receiving).

Performing such a test phase for the processing slice 200 is possible even during actual operation of the signal processing function if the current operational state of the signal processing circuit does not involve any contribution by the processing slice 200. This way, a re-calibration of the processing slice 200 can be performed even while the signal processing operation is ongoing.

Fig. 3 is a block diagram of an exemplary programmable macrocell 300 of processing slices for use in an analog processing array of the type shown under reference label 114 in Fig. 1. The exemplary macrocell 300 comprises three processing slices 302, 304 and 306, which are of the same type as the processing slice 200 shown in Fig. 2. The number of processing slices shown in Fig. 3 is selected for exemplary illustration only. Macrocells may have a different granularity in other embodiments. Macrocells may comprise up to 100 or even up to 1000 processing slices. The number of processing slices in a macrocell is not limited by these examples, but can be determined in view of the requirements of a particular set of application cases to be covered by a given type of PASPA. The number of processing slices per macrocell need not be the same for all macrocells of a given PASPA.

Since the circuit elements of the processing slice 200 are shown in Fig. 2 and have been described above in detail, the present graphical representation omits the details of the internal circuit structure of the processing slices 302 to 306.

To enable the programmable configuration of the macrocell 300, a control element 308 is provided in association with the macrocell 300 and connected with the processing slices 302, 304, and 306 of the macrocell via a macrocell-internal control bus 310. The control element 308 is associated in its control function with the given macrocell 300 and may thus be considered as performing a "satellite" control function under the central control of the configuration control unit 130. The control element 308 comprises a control register for storing applicable configuration signal information. The control register of the control element 308 is programmed and addressed via a global control bus 309 running over the entire PASPA. The programming is performed by the configuration control unit 130 (cf. Fig. 1) via the global control bus 309. Suitably, the configuration control unit 130 thus performs the programming of all macrocells of the PASPA.

In the advantageous layout approach shown in Fig. 3, the control elements 308 of the different macrocells 300 of a PASPA are thus distributed across the processing array and are suitably arranged in local proximity to their respective associated macrocell 300.

In an alternative approach (not shown), the different control elements are spatially grouped together or even implemented in an integrated circuit in a control section of the array that may even be combined with the control unit 130 shown in Fig. 1. In both layout approaches, the control signal flow to the associated macrocell via the control bus 309 suitably involves an identification of the individual macrocell, and may even reach down to the level of an identification of an individual processing slice or a respective switching element or circuit element to be configured with a given configuration control signal.

Furthermore, the processing slices 302 to 306 of the macrocell 300 are each connected to an analog test bus 312. The analog test bus is connected with the configuration control unit 130 to provide the processing slices of the macrocell 300 with analog configuration test signals generated by the configuration control unit. Also, respective individual slice test-response signals provided by the respective cell circuit elements of the processing slices, in response to the one or more configuration test signals are provided back via the analog test bus 312 for evaluation and potential adaptation of the configuration. Such evaluation and adaptation of the configuration is performed by the configuration processor 128.

A clock tree 314 provides a clock signal to the processing slices of the macrocell 300. Moreover, the analog signal bus 316 of the present embodiment includes four different signal bus components, which generally correspond to the signal bus components described in the context of Fig. 2:
- A first signal bus component, herein analog in-out bus 316.1, for receiving the slice input signals and routing them to a pre-configurable set of processing slices and for receiving the slice output signals of the processing slices in accordance with the signal-bus configuration;
- A second signal bus component, herein multiplier bus 316.2, receives the respective delayed slice input signals and transports them to a pre-configurable set of processing slices in accordance with the signal-bus configuration, to form respective multiplier input signals for these processing slices;
- A third signal bus component, herein adder bus 316.3, receives respective multiplier output signals and routes them to a controllable set of processing slices in accordance with the signal-bus configuration, to form respective adder input signals for these processing slices; and
- A fourth signal bus component, herein a resampler bus 316.4 receives the respective adder output signals and transports them to a pre-configurable set of resample elements in accordance with the signal-bus configuration.

Switching elements for static or dynamic control of the routing of the analog data signals on the analog signal bus 316, the clock signal train on the clock tree 312 and the signals on the analog test bus 314 to and between the individual circuit elements of the processing slices 302, 304 and 306 are provided, but not shown here for reasons of graphical simplicity. The control element 308 and the control bus 310 serve for controlling the respective switch settings for establishing desired connections of the circuit elements of the processing slices within the macrocell 300, and the routing of the different signals among them.

Signal communication between different processing slices is possible via each of the four signal bus components 316.1 to 316.4. As an example, an analog slice input signal may be routed to a first processing slice, and the only signal processing task of the first processing slice may be to subject the analog input signal a controlled time delay of a predetermined number of clock cycles. In this exemplary case, the delayed slice input signal will be routed from the delay element of the first processing slice to back to analog in-out-bus 316.1 and output to a predetermined next processing slice in the signal processing flow. Switching elements suitably arranged along the analog in-out bus 316.1 can be used to avoid any undesired signal "collisions" of the delayed slice input signal with other analog slice input signals received by the first processing slice via the in-out bus 316.1.

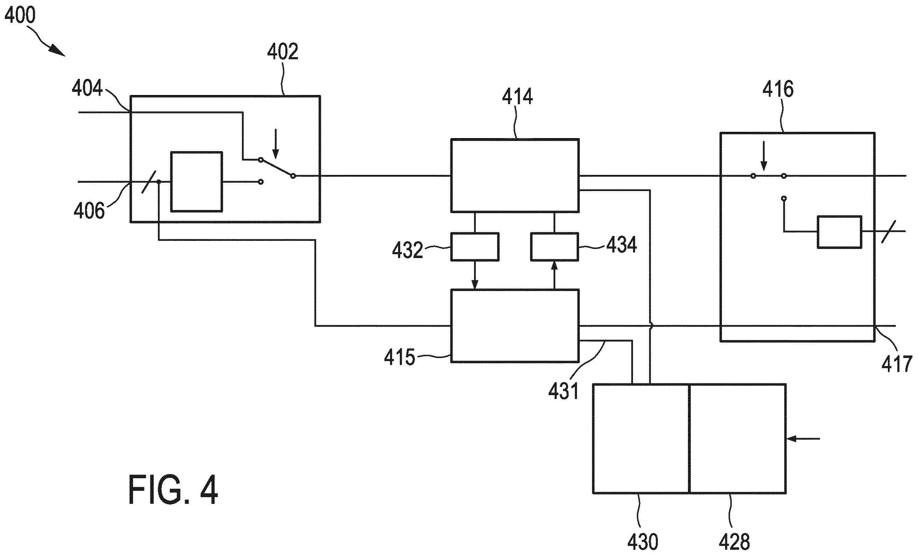

Fig. 4 is a block diagram illustrating a high-level structure of a PASPA 400 according to a further embodiment of the present invention. The following description will concentrate on the differences of the PASPA 400 in comparison with the PASPA 100 shown in Fig. 1. Reference labels that point to elements of the PASPA 400 that correspond to elements already described in the context of Fig. 1 either share the last two digits with those elements or carry no reference label at all. For a more detailed description of these elements of the PASPA 400, reference is thus made to the description of the corresponding elements in Fig. 1.

The PASPA 400 comprises in an input unit 402 with an analog signal input port 404 and a digital signal input port 406. In the present embodiment, the input unit 402 is configured to not only forward received input to the analog processing array 414, but to additionally forward selected received digital data signal words to a programmable digital signal processing array (PDSPA) 415. A suitable switching unit for controlling a selection of digital data words to be forwarded to the PDSPA 415 is not shown here. The PDSPA 415 comprises a programmable network of digital logic gates. In one implementation, digital signal processing array 415 comprises a field programmable gate array (FPGA), as it is per se known in the art. The PDSPA 415 is in one embodiment an integrated component of the PASPA 400, which thus forms a system on chip with an analog processing array 414 and a digital processing array 415. However, other embodiments have the analog processing array 414 and the digital processing array 415 separate chips, suitably in the form of a system in package, or in an arrangement of chips together with peripheral circuitry on a printed circuit board.

Data exchange between the analog processing array 414 and the digital processing array 415 is performed via an analog-to-digital converter (ADC) 432 and a DAC 434. Thus, the PASPA 400 allows efficiently combining the advantages of digital and analog signal processing in a single programmable signal processing array. The programming of both the analog processing array 414 and the digital processing array 415 can be performed using an identical configuration processor 428 and an identical configuration control unit 430. An additional digital configuration control bus 431 provides the configuration signals to the PDSPA 415. As indicated before, it is particularly advantageous that the design process for programming the analog processing array 414 and the digital processing array 415 is substantially identical and thus achieves integration of the design flow of a combined analog and digital signal processing application. The output unit 416 is extended in comparison with that of the embodiment of Fig. 1 by an additional digital output port 417 for the digital output data provided by the PDSPA 415.

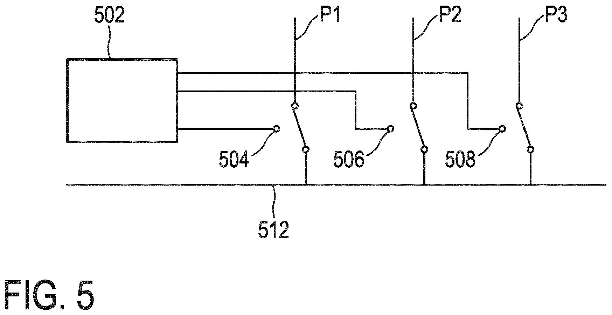

Fig. 5 is a diagram illustrating the configurability of access control between the processing slice of Fig. 2 and the analog test bus. A test switching control register 502 provides control information for controlling the switching state (on/off) of three control switches 504, 506, and 508 that open or close access of the given access point P1, P2, P3 shown in Fig. 2 to the analog test bus 512. The combination of switching states shown in Fig. 5 shown in Fig 5 is purely for illustrative purposes. By selectively controlling the switching states of the control switches 504, 506, and 508, using the control data entries in the test switching control register 502, the routing and reception of analog test signals to the given processing slice and of analog test response signals back to the configuration control unit 130 and configuration processor 128 can be handled effectively.

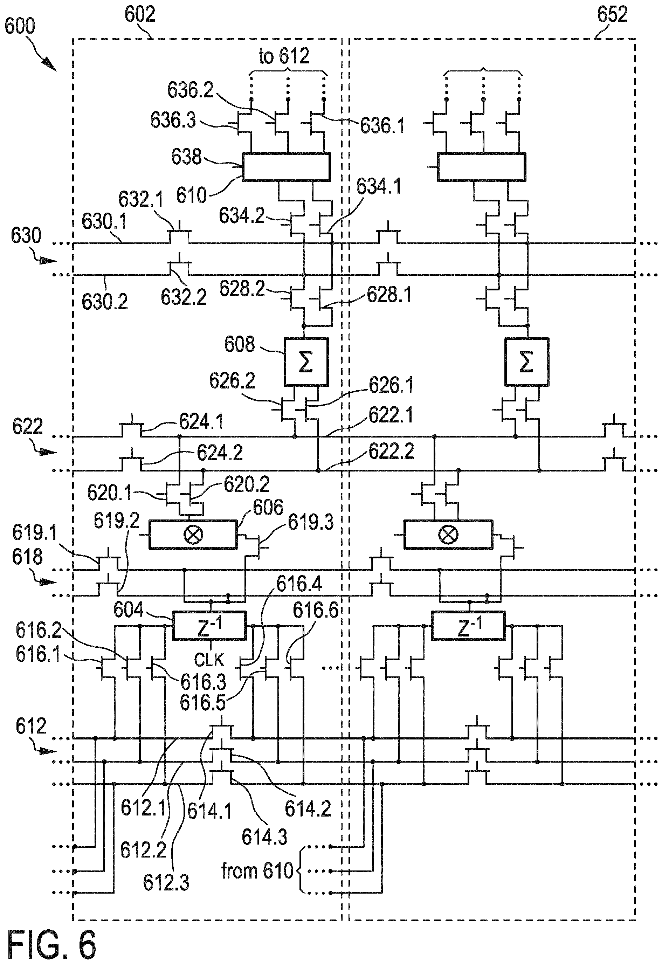

Fig. 6 is a simplified circuit diagram of a section of an analog processing array 600 with two mutually interconnected processing slices 602 and 652. The processing slices 602 and 652 are of identical structure. For that reason, only the processing slice 602 will be described in the following. The processing slice 602 comprises a configurable delay element 604, an analog multiplier element 606, an analog adder element 608 and an analog resample element 610. An in-out bus 612 of an analog signal bus comprises three in-out bus lines 612.1, 612.2 and 612.3 which are segmented and controllably used under the control of a first set of routing switches 614.1, 614.2, and 614.3, which in the present embodiment are FET switches controlled via their respective gate electrode. Access from the in-out bus lines to the delay element 604 for delivering an analog slice input signal and for receiving a delayed slice input signal back at the in-out bus is controlled by a second set of routing switches 616.1 to 616.6. The controllable delay element 604 also receives a clock signal via a clock input port CLK.

A multiplier bus 618 of the analog signal bus connects the output of the controllable delay element 604 with the analog multiplier element 606 of the local processing slice and with the analog multiplier elements of other processing slices downstream in the signal flow for providing the delayed slice input signal to the multiplier element 606 of the processing slice 602 or to any of the multiplier elements of other processing slices downstream in the processing flow. The routing along the multiplier bus is controlled by routing switches 619.1 to 619.3.

The multiplier output signal from the analog multiplier element 606 is controllably fed via routing switches 620.1 and 620.2 to an adder bus 622 of the analog signal bus. In this exemplary embodiment, the adder bus 622 comprises two adder bus lines 622.1 and 622.2, each of which can be selected for carrying the multiplier output signal via an on-off control of the routing switches 620.1 and 620.2. It is noted here that the number of bus lines of the analog signal bus components can be selected according to the discretion of the designer of the PASPA.

Routing along the shown segment of the adder bus 622 and to the inputs of the analog adder element 608 is controlled via a third set of routing switches 624.1, 624.2 and a fourth set of routing switches 626.1 and 626.2, respectively. The adder output signal is fed via a fifth set of routing switches 628.1 and 628.2 to signal lines 630.1 and 630.2 of a resampler bus 630. A sixth set of routing switches 632.1 and 632.2 controls the routing of the analog adder output signals along the resampler bus 630. The analog adder output signal is received by the analog resample element 610 via a seventh set of routing switches, which feeds its slice output signal to the in-out bus 612 via an eighth set of routing switches 636.1 to 636.3 with a suitable cell-output delay. The function of the analog resample element is thus to provide a track-and-hold function. This serves in particular for stabilizing the slice output signal. The cell-output delay is configurable via a resample configuration input 638 of the resample element 610 using control signals provided by the configuration control unit. In other embodiments, an additional local control element (not shown) or macrocell-internal control element as discussed in the context of Fig. 3 (control element 308) may be used for setting and, if necessary, adapting the cell-output delay.

It is noted that throughout the exemplary drawings, the routing switches are shown as single transistors, in particular FETs. However, instead of transistors, other suitable switching elements can be used any of the embodiments disclosed herein. For instance, CMOS-based transmission gates or MEMS switches are suitable alternatives for use as a routing switch. Thus, by suitable control of the routing switches using the control element 308, each processing slice can be programmed to perform a desired signal processing function from a large variety of analog signal processing functions. A particularly simple example is the use as a controllable delay element, as explained in the context of Fig. 3. The further processing and routing options provide combination options of multiplication and summation functions, which in connection with the operation of other processing slices in the programmed signal flow allow implementing a wide range of analog signal processing schemes.

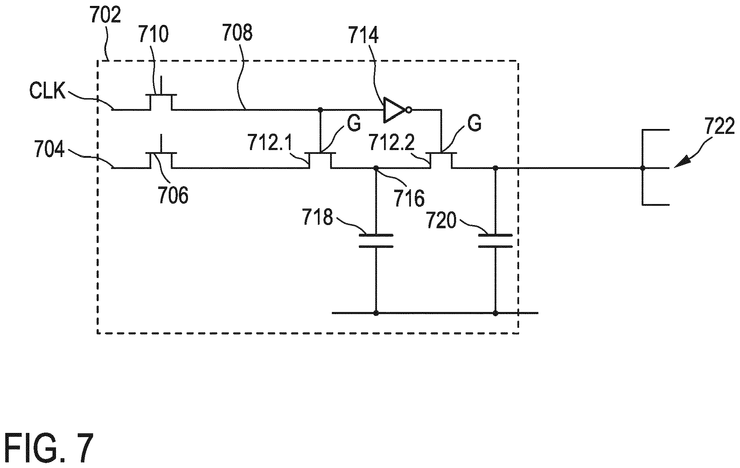

Fig. 7 is a simplified circuit diagram of a delay element 702 suitable for use in a processing slice of a programmable signal processing array of the present invention. A slice input signal is received via an in-out bus 704 (shown by a single bus line for simplicity) and passes a signal routing switch 706. A single two-phase clock signal is received at a clock input CLK and fed to a clock line 708 via a clock routing switch 710. The delay element 702 comprises a series of two (or more) delay control switches 712.1 and 712.2. Each of the delay control switches 712.1 and 712.2 has a control gate G for controlling opening and closing of the respective switch in accordance with the two phases of two non-overlapping clock signal trains received at the respective control gate. In the present example, the delay element 702 receives the single two-phase clock signal train and generates a second, non-overlapping clock signal train by means of an inverter 714 that is arranged downstream of a branch point 716 connecting the control gate G of the first delay control switching element 712.1 with the clock line 708. The second clock signal train is thus generated as a phase-inverted version of the first clock signal train.

The slice input signal received via the in-out bus 704 is fed through the gate-controlled channel of the delay control switches 712.1 and 712.2 and feeds a parallel connection of two capacitors 718 and 720 connected to a reference voltage (e.g., mass), wherein a respective one of the capacitors 718, 722 is arranged downstream of each delay control switch 712.1., 712.2.

In operation, the received slice input signal is forwarded stepwise by means of the control action of the two-phase non-overlapping clock signals, and experiences a delay in terms zero or one clock period, or multiples of the clock signal period, depending on the controlled feeding of the clock signal via the clock routing switch 710. Thus, the delayed slice input signal is provided behind the last switching element in the direction of signal flow to the multiplier bus 722 via respective routing switches (not shown). The delay element thus corresponds to a series connection of two analog latches enables a time-discrete analog signal processing scheme.

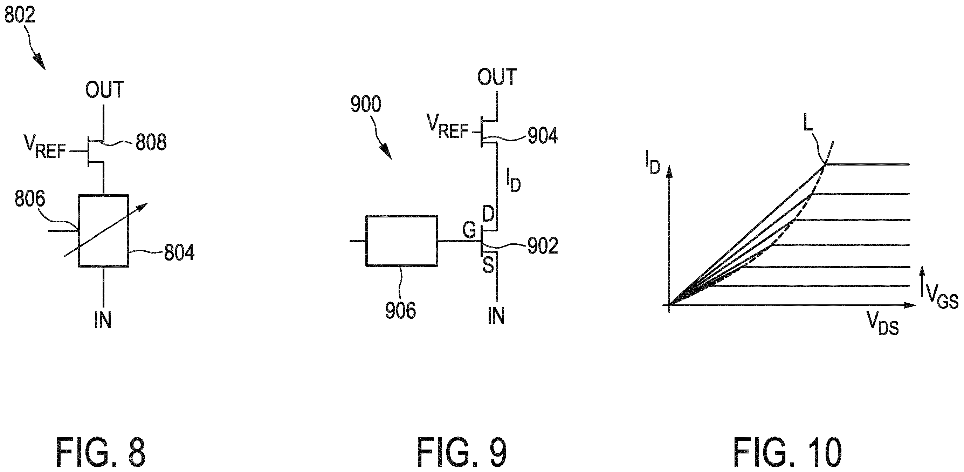

Fig. 8 is a schematic diagram of an analog multiplier element 802 for use in a processing slice. The analog multiplier element 802 receives the delayed slice input signal as a voltage signal at a multiplier input IN. The delayed slice input signal is provided, e.g., by the delay element 702 of Fig. 7. A memristor 804 forms a controllable ohmic resistive element and performs an analog multiplication with a programmable multiplication factor. A control input 806 serves for receiving the multiplication factor from the configuration control unit (cf. Fig. 1, Fig. 3). A transistor 808 serves for providing a reference voltage V_{REF} to a reference input. A voltage V_{REF-} V_{GS} is then provided to the memristor 804, where V_{GS} is the gate-source voltage drop of the transistor 808.

A voltage difference between the voltage V_{REF -} V_{GS} and the multiplier input voltage formed by the delayed slice input signal at the multiplier input IN results in an output current provided at a multiplier output OUT. The output current is proportional to a product of the multiplier input voltage and of the preconfigured multiplication factor of the memristor 804. Thus, the current signal generated by the analog multiplier 802 corresponds to the desired analog product and shows an excellent linearity.

Figs. 9 shows an alternative implementation of an analog multiplier element 900 that comprises a field effect transistor (FET) 902 and a reference transistor 904 for providing a reference voltage V_{REF}. A control gate G of the FET 902 is fed by a digital-analog converter (DAC) 906 that provides the multiplication factor via a digitally programmable, analog control voltage to the control gate G. The control voltage thus depends on the programmed multiplication factor. The control voltage determines a gate-to-source voltage V_{GS} applied to the FET 902, which in turn determines a channel resistance of the FET 902 and thus controls the drain current I_{D} flowing from a drain electrode D through the channel of the FET and the source electrode due to the voltage difference between the multiplier input voltage and the voltage V_{REF -} V_{GS'}, wherein V_{GS'} is the gate-source voltage drop at the reference transistor 904. In operation of the analog multiplier element 900, a multiplier input voltage is applied to the FET 902 via its source electrode 902. An output current at the multiplier output OUT is provided by the drain current I_{D}, which is in correspondence with a product of the multiplier input voltage at the multiplier input IN and the multiplication factor. The multiplier output signal is thus provided in the form of a current signal.

Additional reference is now made to Fig. 10, which is a diagram showing the drain current I_{D} vs. the drain-to-source voltage V_{DS} for several values of V_{GS}. For an operation as an analog multiplier, the FET is operated in a linear range to the left (i.e. lower V_{DS}) of the dotted line L. With a given multiplier input voltage applied to the drain D of the FET 902, a drain current I_{D} will be output that depends on the control voltage applied to the gate electrode G, i.e., on the gate-to-source voltage V_{GS}. As can be seen from Fig. 10, increasing V_{DS} in the linear range of the FET at a fixed V_{GS}, i.e., multiplication factor, will result in a linear increase of the drain current I_{D}. The drain current thus is proportional to a product of the drain-to-source voltage, i.e., multiplier input voltage, with a multiplication factor that is determined by the gate-to-source voltage V_{GS}. Furthermore, if the multiplication factor is to be set (programmed) to a higher value for a given multiplier input voltage (V_{DS}), the gate-to-source voltage V_{GS} can be set to a higher value via DAC 906. This will result in a steeper linear increase of the drain current I_{D} as a function of the drain-to-source voltage V_{DS}, which thus corresponds to the desired increased multiplication factor. Prestored data of the characteristic diagram of the FET 902 as visualized by Fig. 10 thus forms the basis for proper programming of the multiplication factor of the analog multiplier 900 by the configuration control unit 130.

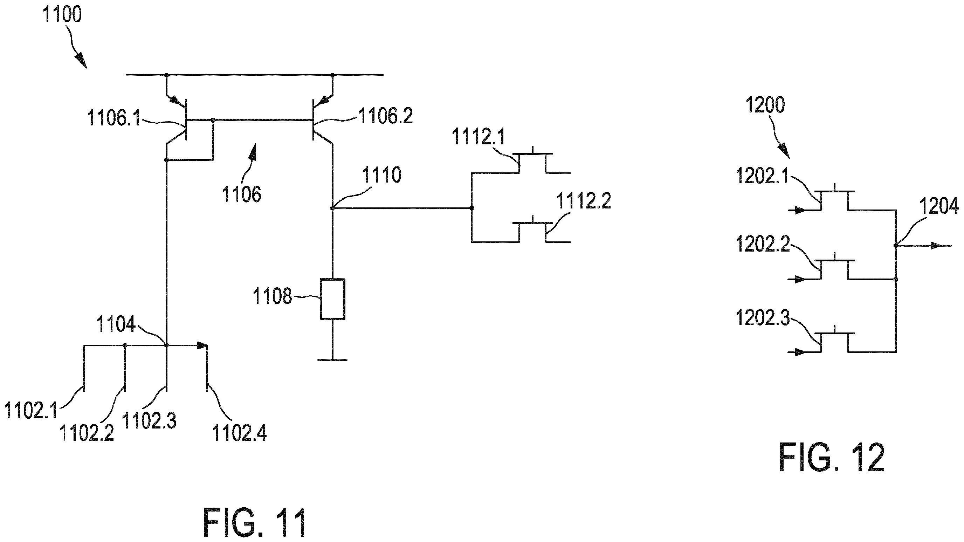

Fig. 11 shows a circuit diagram of an exemplary analog adder element 1100 suitable for use in a processing slice. Four adder input ports 1102.1 to 1102.4 receiving respective adder input signals in the form of current signals. The number of four adder input signals is selected as an example only. Other numbers of input signals can be used at the discretion of the circuit designer in accordance with the requirements of a given application case. The received input current signals are merged and thus added at a node 1104. The resulting current sum is fed into a current mirror 1106 formed of two pnp transistors 1106.1 and 1106.2, which are connected to a power supply (not shown) supplying a constant dc operating voltage. The mirrored current provided by a collector of transistor 1106.2 is subjected to current-voltage conversion using a resistor 1108, and an output voltage is provided as a common-mode voltage level at an output node 1110 for feeding to the resampler bus (not shown) and into a subsequent resampler element (not shown) via routing switches 1112.1 and 1112.2.

The adder element 1100 thus receives current input signals via the adder input ports 1102.1 to 1102.4 and provides an adder output signal in the form of an output voltage that has an amount, which is derived from and indicative of the sum of the received input current amounts .

Fig. 12 shows a circuit diagram of another exemplary adder element 1200 suitable for use in a processing slice. The present embodiment serves for adding two adder input signals that are provided in the form of current signals. Three adder input ports 1202.1 to 1202.3 serve for receiving respective adder input signals in the form of electrical current amounts. Again, the number of input ports is of exemplary nature and may be varied by the circuit designer. In the present embodiment, the adder input ports comprise routing switches, which allow a programmable selection of a number of input ports to be used in a given application case. It is noted that this form of programmable selection of adder input ports can also be used in the embodiment of Fig. 11. The input signals are fed together at a nodal point 1204, so that the input current amounts of the selected input signals add up and a sum of the input current amounts is provided as the adder output signal. In contrast to the embodiment of Fig. 11, the adder element 1200 thus keeps the analog signal in the current plane.

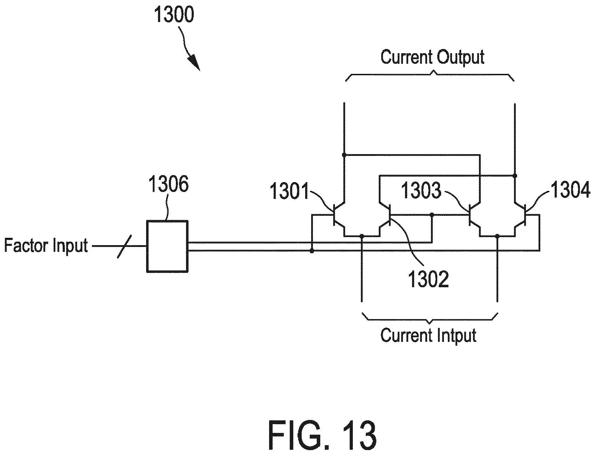

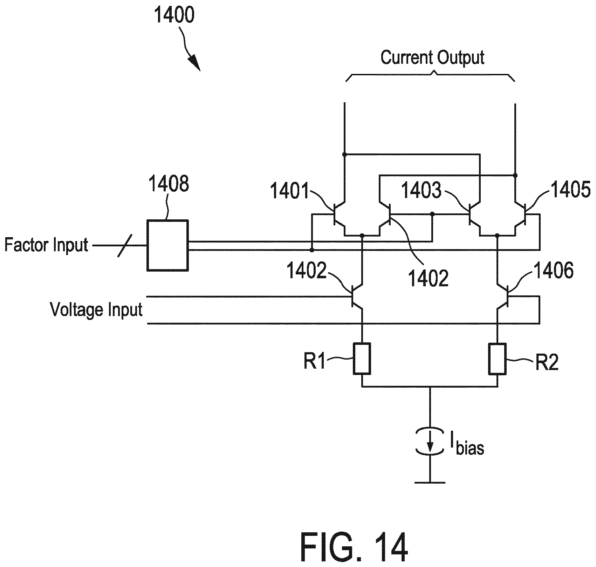

Figs. 13 and 14 show circuit diagrams of further exemplary analog multiplier elements 1300 and 1400, respectively.

The analog multiplier element 1300 is a four-quadrant multiplier circuit that comprises two cross-coupled, emitter-coupled transistor pairs 1301, 1302 and 1303, 1304. It receives an input signal in the form of a delayed slice input current signal, and a digital factor input that is converted to an analog multiplication factor control voltage by a DAC 1306. The multiplier element 1300 provides a current output signal at connected outputs with opposite phase and of a current amount that corresponds to the product of the input current amount with the multiplication factor programmed via the DAC 1306.

The analog multiplier element 1400 is a four-quadrant circuit in the form a Gilbert multiplier cell. It comprises two cross-coupled, emitter-coupled transistor pairs 1501, 1504 and 1503, 1505 in series connection with an emitter-coupled transistor pair 1502, 1506, which feeds the cross-coupled pairs via the collectors of its transistors. The emitter-coupled transistor pair 1502, 1506 is fed by a bias current I_{bias} via two resistors R1, R2 of equal resistance. In contrast to the multiplier element 1300, the analog multiplier element 1400 receives the delayed slice input signal not as a current signal but as an voltage signal. As in the circuit of Fig. 13, the multiplication factor is provided in digital form and converted to an analog voltage signal by a DAC 1408. The multiplication factor is provided to respective base contacts of the emitter-coupled transistor pairs 1501, 1504 and 1503, 1505. The multiplier element 1400 provides a current output of a current amount that corresponds to the product of the input voltage amount with the factor.

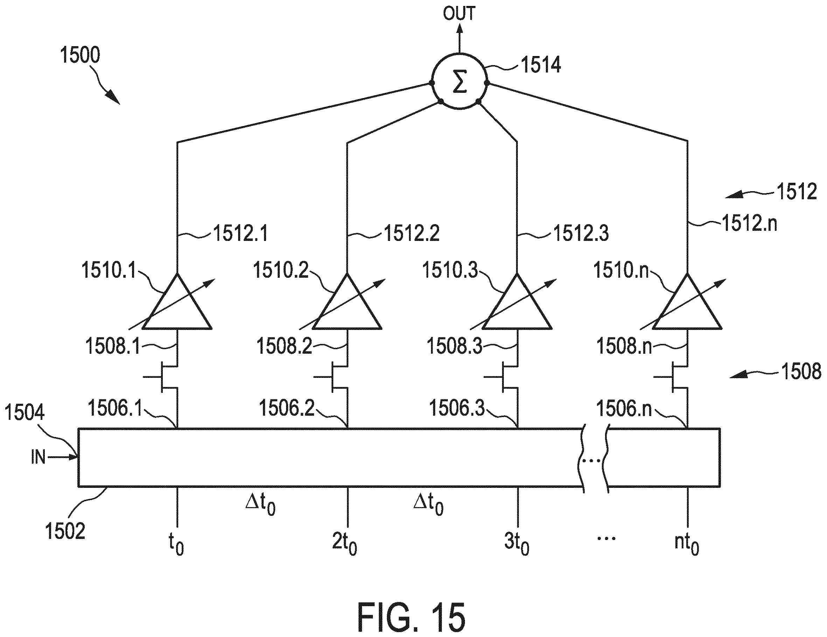

Fig. 15 is a schematic illustration of another embodiment of a processing slice 1500 for use in another embodiment of a PASPA. A true-time delay line 1502 received an analog input signal via an input port 1504. The input signal travels along the true-time delay 1502 line with a known propagation speed (in the current example, from left to right). As it travels along the true-time delay line 1502, the slice input signal experiences a continuously increasing delay due to its finite propagation speed. The delay element 1500 comprises a plurality of delay outputs ports 1506.1, 1506.2, 1506.3, ..., 1506.n , which in the present example are arranged with equal spatial distance from their respective next neighboring output ports. This way, each of the delay output ports allows retrieving a respective delay output signal exhibiting a stepwise increase Δt₀ of the delay exhibited by the respective slice output signal in comparison with its next preceding delay output port. A desired delay output signal can be selected for forwarding to a respective bus line 1508.1, 1508.2, 1508.3, ..., 1508.n of a multiplier bus 1508 using a set of routing switches 1506.1, 1506.2, 1506.3, ..., 1506.n. Thus, by selecting a specific delay output port for providing its respective output signal as the delayed slice input signal, a control of the time delay exhibited by the delayed slice input signal is achieved. A maximum delay amount is achieved by retrieving the output signal at the output 1508.n of the true-time delay line. The number n of output ports can be selected according to the discretion of the designer.

Each of the bus lines 1508.1, 1508.2, 1508.3, ..., 1508.n of the multiplier bus 1508 provides an input signal to an associated analog multiplier element 1510.1, 1510.2, 1510.3, ..., 1510.n, which in the present case are provided in the form of respective variable gain amplifiers that receive their respective multiplication factor via respective control input ports.

The multiplier output signals are fed to respective bus lines 1512.1, 1512.2, 1512.3., ..., 1512.n of an adder bus 1512 to form respective adder input signals of an analog adder 1514, which provides an adder output signal for instance in the form of a current signal to a resample bus (not shown) for feeding to a resampler (also not shown).

The processing slice 1500 is particularly advantageous for analog signal processing of very-high-frequency analog signals.

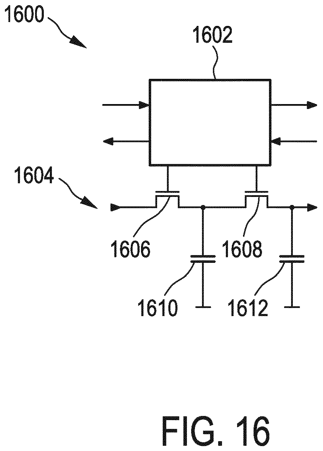

Fig. 16 is an illustration of a further implementation of a controllable delay element 1600 that uses a handshake concept in the signal communication between processing slices, as an alternative to the provision of a central clock signal for driving the controllable delay elements. The key concept of this implementation is a local delay control using a hand-shake circuit 1602 that controls a delay element 1604. The handshake circuit 1602 is associated with a processing slice or a macrocell of processing slices (not shown in Fig. 16) and controls the signal flow to and from other processing slices or macrocells.

In this embodiment, the analog signal bus is associated with and controlled by at least one hand-shake line for transporting communication control signals between the processing slices in accordance with a handshake protocol. The handshake circuit 1602 is configured to
- generate and provide communication control signals on behalf of the respective associated processing slice or macro cell for asynchronous communication with other processing slices or macro cells of the network of processing slices or macro cells in accordance with a handshake protocol;
- control the time delay in providing the delayed slice input signal by the delay element, and to
- control a timing of an output of the multiplier output signal, or of the adder out-put signal via the signal bus in response to a protocol exchange with at least one target processing slice in accordance with the handshake protocol.

The communication control signals exchanged between handshake circuits of the processing slices or macrocells include requests for data transmissions and acknowledgement signals for acknowledging received requests.

The delay element circuit 1604 is similar to the delay element 702 shown in Fig. 7, except for not providing for an inversion of a received clock signal. Instead, it only comprises a series connection of two analog latches, wherein each analog latch comprises a respective delay control switch 1606, 1608, and a respective capacitor 1610, 1612. The on-off control of the delay control switches is performed by the handshake circuit 1602, which thus controls the delay effected by the delay element 1600.

The operation of the entire programmable analog signal processing array with asynchronous handshake signals, e.g. 4-phase handshake, and without any clock avoids or reduces unwanted influences of the clock signal on analog signal values due to, e.g., capacitive couplings or dips of an operating voltage.

In summary, a programmable analog processing array for programmable time-discrete processing of analog input signals in accordance with a desired signal processing function comprises a network of mutually interconnectable and pre-configurable analog processing slices that form unit circuit cells of the network. Each processing slice comprises a set of cell circuit elements including: a switchable clock input port for receiving a clock signal, a delay element for receiving a respective analog slice input signal and for forwarding the received slice input signal with a pre-configurable time delay as a respective delayed slice input signal, an analog multiplier element receiving the delayed slice input signal for providing an analog multiplier output signal corresponding to a product of the delayed slice input signal with a pre-configurable multiplication factor, an analog adder element receiving a pre-configurable selection of at least two adder input signals including the multiplier output signal and for providing an analog adder output signal corresponding to a sum of the adder input signals, and including an analog resample element for receiving the adder output signal and for providing the received adder output with a pre-configurable time delay as an analog slice output signal.

## Claims

1. A programmable analog processing array (100) for programmable time-discrete processing of incoming analog input signals in accordance with a desired signal processing function and for providing processed analog output signals in accordance with the signal processing function, the processing array comprising:
- a network (114) of mutually interconnectable and pre-configurable analog processing slices (200) that form unit circuit cells of the network (114) and that each comprise a set of cell circuit elements formed by
- a switchable clock input port (CLK) for receiving a clock signal;
- a delay element (202) for receiving a respective analog slice input signal and for forwarding the received slice input signal with a pre-configurable time delay as a respective delayed slice input signal;
- an analog multiplier element (206) receiving the delayed slice input signal, for providing an analog multiplier output signal corresponding to a product of the delayed slice input signal with a pre-configurable multiplication factor, and
- an analog adder element (210) receiving a pre-configurable selection of at least two adder input signals including the multiplier output signal, for providing an analog adder output signal corresponding to a sum of the adder input signals; and
- an analog resample element (212) for receiving the adder output signal and for providing the received adder output with a pre-configurable time delay as an analog slice output signal;
- a pre-configurable analog signal bus (108) for receiving and providing the analog input signals to the network (114) of processing slices (200) and for interconnecting any given processing slice (200) to one or more respective other of the processing slices of the network (114) of processing slices (200) to transport the slice input signals and slice output signals;
- a configuration-signal bus (132) for receiving and routing respective configuration control signals to the individual processing slices, wherein the respective configuration control signals are for configuring
- individual time delays of the respective delay elements (202),
- individual multiplication factors of the respective multiplier elements (206),
- individual selections of adder input signals to the respective adder elements (212),
- individual switchable interconnections of the respective processing slices (200) to the analog signal bus (108) for routing, in accordance with a programmable signal-bus configuration and with the signal processing function, the input signals, the respective slice input signals, and the respective slice output signals between the processing slices via the analog signal bus; and, connected to the network of processing slices,
- individual switching states of the clock input ports for allowing or blocking the provision of the clock signal to the respective processing slices;
- a configuration control unit (130) for receiving a configuration code and for using the configuration code to generate the configuration control signals to configure the network (114) of processing slices (200) for implementing an analog signal processing circuit that in operation performs the desired signal processing function.

2. The programmable analog signal processing array of claim 1, wherein
- the delay element (202) is configured to receive the respective analog slice input signal as a first analog voltage signal and to provide the respective delayed slice input signal as a second analog voltage signal,
- the analog multiplier element (206) is configured to provide the analog multiplier output signal as a first analog current signal, and
- the analog adder element (210) is configured to receive the at least two adder input signals as analog current signals and to provide the analog adder output signal also as an analog current signal of an amount indicative of the sum of the adder input signals, and wherein
- the resampling element (212) comprises a current-to-voltage converter for receiving the analog adder output signal and for providing as the slice output signal an adder output voltage signal of an output voltage amount indicative of the current amount of the analog adder output signal; and wherein
- a voltage plane of the slice output voltage signal of the current-to-voltage converter is the same as that of the slice input signal received by the delay element (202).

3. The programmable analog signal processing array of claim 1 or 2, further comprising
- a configuration input port (126) for receiving hardware description data defining, using a hardware description language, a structure and behavior of an analog signal processing circuit performing a signal processing function and to be implemented by the programmable analog signal processing array (100);
- a configuration processor (128) for transforming the hardware description data into net list data indicative of a net list of processing slices and for transforming the net list data into place-and-route data indicative of place-and-route information to be implemented using the network (114) of processing slices (200) and determining desired interconnections of the processing slices (200) that implement the analog signal processing circuit, and for transforming the net list and the place-and-route data into the configuration code.

4. The programmable analog signal processing array of claim 3, wherein
- the configuration processor (128) is further configured to generate, using the hardware description data, desired slice response data that is indicative of individual desired delayed slice input signals of the respective cell circuit elements of the individual processing slices in response to one or more predetermined analog configuration test signals;
- the programmable analog signal processing array (100) further comprises an analog test bus (134, 214, 312), which is connected with the configuration control unit (130) and which is connectable with the individual processing slices (200, 302, 304, 306) to provide them with the one or more analog configuration test signals generated by the configuration control unit (130) and to provide the configuration control unit (130) with respective individual slice test-response signals provided by the respective cell circuit elements of the processing slices (200), each in response to the one or more configuration test signals; wherein
- the configuration control unit (130) is configured to generate the one or more predetermined configuration test signals and to determine deviations of the received slice test-response signals from the desired slice response data in accordance with predetermined deviation criteria, and in case of determining a deviation for a given processing slice (200), to generate the adapted configuration data for the respective processing slice and use the adapted configuration data for providing one or more adapted configuration signals to the respective processing slice.

5. The programmable analog processing array of claim 3 or of claim 4 insofar as dependent on claim 3, further comprising a configuration memory for storing the net list, the place-and-route data, the configuration code, the configuration data and the adapted configuration data.

6. The programmable analog signal processing array of any of the preceding claims, wherein the multiplier element of the processing slices comprises a configurable memristor (804), which receives the delayed slice input signal and which is configured to provide the multiplier output signal as a current signal of a current amount that is indicative of a product of an input voltage amount of the delayed slice input signal multiplied by the multiplication factor.

7. The programmable analog signal processing array of claim 6, wherein the configuration control unit (130) is configured
- to use the configuration input data or, if present, the adapted configuration data to determine respective memristor configuration signal amounts to be applied to the respective memristor (804) of the multiplier elements (802) of the individual processing slices to set a respective multiplication weight factor of the respective multiplier element, and
- to subject the respective memristor (804) of the multiplier elements to the determined configuration signal of the determined configuration signal amount.

8. The programmable analog processing array of claims 4 and 7, wherein the configuration control unit (130) is configured
- to switch to an intermittent background calibration mode under operation of the processing array (100), and, in the background calibration mode,
- to generate and provide via the analog test bus (134, 214, 312) one or more multiplier test signals to the multiplier elements (802),
- to determine from the received multiplier output signals a deviation of a respective multiplication factors from the respective desired multiplication factors according to the configuration code; and, in case of a determining a deviation,
- to generate and provide a respective memristor re-configuration signal amount to be applied to the respective memristor (804) of the multiplier elements (802) of the individual processing slices in order to re-set the respective multiplication factor of the respective multiplier element (802) to the desired value; and
- to subject the respective memristor (804) of the multiplier elements (802) to the determined respective reconfiguration signal amount.

9. The programmable analog signal processing array any of the preceding claims, wherein the analog signal bus (316) comprises
- a first signal bus, hereinafter analog in-out bus (316.1), for receiving the slice input signals and routing them to a pre-configurable set of processing slices (200) and for receiving the slice output signals of the processing slices in accordance with the signal-bus configuration;
- a second signal bus, hereinafter multiplier bus (316.2), for receiving the respective delayed slice input signals and routing them to a pre-configurable set of processing slices (200) in accordance with the signal-bus configuration;
- a third signal bus, hereinafter adder bus (316.3), for receiving the respective multiplier output signals and routing them to a controllable set of processing slices (200) in accordance with the signal-bus configuration;
- a fourth signal bus, hereinafter adder output bus, for receiving the respective adder output signals and routing them to a pre-configurable set of resample elements (212) in accordance with the signal-bus configuration and to an output of the processing array (100),
wherein the analog in-out bus (316.1), the multiplier bus (316.2), the adder bus (316.3) and the adder output bus are each switchably interconnectable with each of the processing slices in accordance with the signal-bus configuration.

10. The programmable analog signal processing array of any of the claims 5 to 9, wherein
- the network of processing slices is divided into identical macrocells (300) that each comprise a plurality of processing slices (302, 304, 306),
- the configuration control unit (160) is configured to use the configuration code for generating respective configuration signals that establish desired electrical connections between the processing slices (302, 304, 306) of a given macrocell (300);
- each of the macrocells (300) has an associated control element (308) that receives the configuration signals associated with the processing slices (302, 304, 306) of the given macrocell (300) from the configuration control unit (130) for controlling a routing of
- the configuration signals to the respective processing slices (302, 304, 306) of the given macrocell (300),
- the configuration test signals associated with the processing slices (302, 304, 306) of the given macrocell (300) and the slice test-response signals in response to the configuration test signals from the processing slices of the given macrocell via the analog test bus (312),
- the clock signal to the respective processing slices (302, 304, 306) of the given macrocell (300); and of
- analog data signals between the processing elements of the processing slices (302, 304, 306) via the analog signal bus (316).

11. The programmable analog signal processing array of any of the preceding claims, further comprising a clock generation unit configured to provide a pair of two-phase non-overlapping clock signal trains to the processing slices (200) via the clock bus.

12. The programmable analog signal processing array of any of the preceding claims, wherein
the delay element (702) of the processing slices comprises a series of at least two switching elements (712.1, 712.2) that receives the slice input signal, each of the switching elements also having a control gate (G) receiving a respective one of the clock signal (CLK) trains for opening and closing the switching element in accordance with the two phases of the respective clock signal train, and wherein the delay element (702) further comprises parallel capacitances (718, 720) respectively arranged behind, in a direction of signal flow, each switching element (712.1, 712.2), for providing the delayed slice input signal behind the last switching element in the direction of signal flow.

13. The programmable analog signal processing array of any of the claims 1 to 10, wherein
- the analog signal bus is associated with and controlled by at least one handshake line for transporting communication control signals between the processing slices in accordance with a handshake protocol;
- the processing slices or, if present, macro cells each further comprise an associated hand-shake circuit (1602) which is configured to
- generate and provide communication control signals on behalf of the respective associated processing slice or macro cell for asynchronous communication with other processing slices or macro cells of the network of processing slices or macro cells in accordance with a handshake protocol;
- control the time delay in providing the delayed slice input signal by the delay element (1604), and to
- control a timing of an output of the multiplier output signal, or of the adder output signal via the signal bus in response to a protocol exchange with at least one target processing slice in accordance with the handshake protocol.

## Patentansprüche

1. Programmierbare analoge Verarbeitungsanordnung (100) zur programmierbaren zeitdiskreten Verarbeitung eingehender analoger Eingangssignale gemäß einer gewünschten Signalverarbeitungsfunktion und zur Bereitstellung verarbeiteter analoger Ausgangssignale gemäß der Signalverarbeitungsfunktion, wobei die Verarbeitungsanordnung umfasst:
- ein Netzwerk (114) aus miteinander verbindbaren und vorkonfigurierbaren analogen Verarbeitungsabschnitten (200), die Einheitsschaltungszellen des Netzwerks (114) bilden und die jeweils einen Satz von Zellenschaltungselementen umfassen, die gebildet werden durch
- einen schaltbaren Takteingangsanschluss (CLK) zum Empfang eines Taktsignals;
- ein Verzögerungselement (202) zum Empfangen eines jeweiligen analogen Abschnittseingangssignals und zum Weiterleiten des empfangenen Abschnittseingangssignals mit einer vorkonfigurierbaren Zeitverzögerung als ein jeweiliges verzögertes Abschnittseingangssignal;
- ein analoges Multiplikatorelement (206), das das verzögerte Abschnittseingangssignal empfängt, um ein analoges Multiplikatorausgangssignal bereitzustellen, das einem Produkt aus dem verzögerten Abschnittseingangssignal und einem vorkonfigurierbaren Multiplikationsfaktor entspricht, und
- ein analoges Addiererelement (210), das eine vorkonfigurierbare Auswahl von mindestens zwei Addierereingangssignalen einschließlich des Multiplikatorausgangssignals empfängt, um ein analoges Addiererausgangssignal bereitzustellen, das einer Summe der Addierereingangssignale entspricht; und
- ein analoges Resampling-Element (212) zum Empfangen des Addiererausgangssignals und zum Bereitstellen des empfangenen Addiererausgangssignals mit einer vorkonfigurierbaren Zeitverzögerung als ein analoges Abschnittsausgangssignal;
- einen vorkonfigurierbaren Analogsignalbus (108) zum Empfangen und Bereitstellen der analogen Eingangssignale an das Netzwerk (114) von Verarbeitungsabschnitten (200) und zum Verbinden jedes beliebigen Verarbeitungsabschnittes (200) mit einer oder mehreren jeweiligen anderen der Verarbeitungsabschnitte des Netzwerks (114) von Verarbeitungsabschnitten (200), um die Abschnittseingangssignale und Abschnittsausgangssignale zu transportieren;
- einen Konfigurationssignalbus (132) zum Empfangen und Weiterleiten jeweiliger Konfigurationssteuersignale an die einzelnen Verarbeitungsabschnitte, wobei die jeweiligen Konfigurationssteuersignale zum Konfigurieren
- jeweiliger Zeitverzögerungen der jeweiligen Verzögerungselemente (202),
- jeweiliger Multiplikationsfaktoren der jeweiligen Multiplikatorelemente (206),
- jeweiliger Auswahlen von Addierereingangssignale der jeweiligen Addiererelemente (212),
- jeweiliger schaltbarer Verbindungen der jeweiligen Verarbeitungsabschnitte (200) mit dem analogen Signalbus (108), um in Übereinstimmung mit einer programmierbaren Signalbuskonfiguration und mit der Signalverarbeitungsfunktion die Eingangssignale, die jeweiligen Abschnittseingangssignale und die jeweiligen Abschnittsausgangssignale zwischen den Verarbeitungsabschnitten über den analogen Signalbus zu leiten;
Und, mit dem Netzwerk der Verarbeitungsabschnitte verbunden,
- jeweiliger Schaltzustände der Takteingangsports, um die Bereitstellung des Taktsignals für die jeweiligen Verarbeitungsabschnitte zu ermöglichen oder zu sperren;
- eine Konfigurationssteuereinheit (130) zum Empfangen eines Konfigurationscodes und zum Verwenden des Konfigurationscodes, um die Konfigurationssteuersignale zu erzeugen, um das Netzwerk (114) von Verarbeitungsabschnitten (200) zum Implementieren einer analogen Signalverarbeitungsschaltung zu konfigurieren, die im Betrieb die gewünschte Signalverarbeitungsfunktion durchführt.

2. Programmierbare analoge Signalverarbeitungsanordnung nach Anspruch 1, wobei
- das Verzögerungselement (202) so konfiguriert ist, dass es das jeweilige analoge Abschnittseingangssignal als ein erstes analoges Spannungssignal empfängt und das jeweilige verzögerte Abschnittseingangssignal als ein zweites analoges Spannungssignal bereitstellt,
- das analoge Multiplikatorelement (206) so konfiguriert ist, dass es das analoge Multiplikatorausgangssignal als ein erstes analoges Stromsignal bereitstellt, und
- das analoge Addiererelement (210) so konfiguriert ist, dass es die mindestens zwei Addierereingangssignale als analoge Stromsignale empfängt und das analoge Addiererausgangssignal auch als ein analoges Stromsignal mit einem Betrag bereitstellt, der die Summe der Addierereingangssignale anzeigt, und wobei
- das Resampling-Element (212) einen Strom-Spannungs-Wandler umfasst zum Empfangen des analogen Addiererausgangssignals und zum Bereitstellen eines Addiererausgangsspannungssignals als das Abschnittsausgangssignal, mit einem Ausgangsspannungsbetrag, der den Strombetrag des analogen Addiererausgangssignals anzeigt; und wobei
- eine Spannungsebene des Abschnittsausgangsspannungssignals des Strom-Spannungs-Wandlers die gleiche ist wie die des Abschnittseingangssignals, das von dem Verzögerungselement (202) empfangen wird.

3. Programmierbare analoge Signalverarbeitungsanordnung nach Anspruch 1 oder 2, die ferner umfasst
- einen Konfigurationseingangsanschluss (126) zum Empfangen von Hardwarebeschreibungsdaten, die unter Verwendung einer Hardwarebeschreibungssprache eine Struktur und ein Verhalten einer analogen Signalverarbeitungsschaltung definieren, die eine Signalverarbeitungsfunktion durchführt und durch die programmierbare analoge Signalverarbeitungsanordnung (100) implementiert werden soll;
- einen Konfigurationsprozessor (128) zum Umwandeln der Hardwarebeschreibungsdaten in Netzlistendaten, die eine Netzliste von Verarbeitungsabschnitten anzeigen, und zum Umwandeln der Netzlistendaten in Place-and-Route-Daten, die Place-and-Routelnformationen anzeigen, die unter Verwendung des Netzwerks (114) von Verarbeitungsabschnitten (200) zu implementieren sind, und zum Bestimmen gewünschter Verbindungen der Verarbeitungsabschnitte (200), die die analoge Signalverarbeitungsschaltung implementieren, und zum Umwandeln der Netzliste und der Place-and-Route-Daten in den Konfigurationscode.

4. Programmierbare analoge Signalverarbeitungsanordnung nach Anspruch 3, wobei
- der Konfigurationsprozessor (128) ferner so konfiguriert ist, dass er unter Verwendung der Hardware-Beschreibungsdaten gewünschte Abschnitts-Antwortdaten erzeugt, die jeweilige gewünschte verzögerte Abschnittseingangssignale der jeweiligen Zellschaltungselemente der jeweiligen Verarbeitungsabschnitte in Reaktion auf ein oder mehrere vorbestimmte analoge Konfigurationstestsignale anzeigen;
- die programmierbare analoge Signalverarbeitungsanordnung (100) ferner einen analogen Testbus (134, 214, 312) umfasst, der mit der Konfigurationssteuereinheit (130) verbunden ist und der mit den jeweiligen Verarbeitungsabschnitten (200, 302, 304, 306) verbindbar ist, um sie mit dem einen oder den mehreren analogen Konfigurationstestsignalen zu versorgen, die von der Konfigurationssteuereinheit (130) erzeugt werden, und um die Konfigurationssteuereinheit (130) mit jeweiligen individuellen Abschnittstestantwortsignalen zu versorgen, die von den jeweiligen Zellschaltungselementen der Verarbeitungsabschnitte (200) jeweils als Reaktion auf das eine oder die mehreren Konfigurationstestsignale bereitgestellt werden; wobei
- die Konfigurationssteuereinheit (130) konfiguriert ist, um das eine oder die mehreren vorbestimmten Konfigurationstestsignale zu erzeugen und Abweichungen der empfangenen Abschnittstestantwortsignale von den gewünschten Abschnittsantwortdaten in Übereinstimmung mit vorbestimmten Abweichungskriterien zu bestimmen und im Fall der Bestimmung einer Abweichung für einen bestimmten Verarbeitungsabschnitt (200) die angepassten Konfigurationsdaten für den jeweiligen Verarbeitungsabschnitt zu erzeugen und die angepassten Konfigurationsdaten zu verwenden, um ein oder mehrere angepasste Konfigurationssignale für den jeweiligen Verarbeitungsabschnitt bereitzustellen.

5. Programmierbare analoge Verarbeitungsanordnung nach Anspruch 3 oder nach Anspruch 4, soweit von Anspruch 3 abhängig, weiter umfassend einen Konfigurationsspeicher zum Speichern der Netzliste, der Place-and-Route-Daten, des Konfigurationscodes, der Konfigurationsdaten und der angepassten Konfigurationsdaten.

6. Programmierbare analoge Signalverarbeitungsanordnung nach einem der vorhergehenden Ansprüche, wobei das Multiplikatorelement der Verarbeitungsabschnitte einen konfigurierbaren Memristor (804) umfasst, der das verzögerte Abschnittseingangssignal empfängt und der so konfiguriert ist, dass er das Multiplikatorausgangssignal als ein Stromsignal mit einem Strombetrag bereitstellt, der ein Produkt eines Eingangsspannungsbetrags des verzögerten Abschnittseingangssignals, multipliziert mit dem Multiplikationsfaktor, anzeigt.

7. Programmierbare analoge Signalverarbeitungsanordnung nach Anspruch 6, wobei die Konfigurationssteuereinheit (130) konfiguriert ist,
- die Konfigurationseingangsdaten oder, falls vorhanden, die angepassten Konfigurationsdaten zu verwenden, um jeweilige Memristor-Konfigurationssignalbeträge zu bestimmen, die an den jeweiligen Memristor (804) der Multiplikatorelemente (802) der einzelnen Verarbeitungsabschnitte anzulegen sind, um einen jeweiligen Multiplikationsgewichtungsfaktor des jeweiligen Multiplikatorelements einzustellen, und
- den jeweiligen Memristor (804) der Multiplikatorelemente mit dem ermittelten Konfigurationssignal der ermittelten Konfigurationssignalbeträge zu beaufschlagen.

8. Programmierbare analoge Verarbeitungsanordnung nach Anspruch 4 und 7, wobei die Konfigurationssteuereinheit (130) konfiguriert ist,
- in einen intermittierenden Hintergrundkalibrierungsmodus während des Betriebs der Verarbeitungsanordnung (100) umzuschalten, und, in dem Hintergrundkalibrierungsmodus,
- über den analogen Testbus (134, 214, 312) ein oder mehrere Multiplikatortestsignale zu erzeugen und an die Multiplikatorelemente (802) zu liefern,
- aus den empfangenen Multiplikatorausgangssignalen eine Abweichung eines jeweiligen Multiplikationsfaktors von den jeweiligen gewünschten Multiplikationsfaktoren gemäß dem Konfigurationscode zu bestimmen; und, im Falle einer Bestimmung einer Abweichung,
- einen jeweiligen Memristor-Rekonfigurations-Signalbetrag zu erzeugen und bereitzustellen, der an den jeweiligen Memristor (804) der Multiplikatorelemente (802) der einzelnen Verarbeitungsabschnitte angelegt wird, um den jeweiligen Multiplikationsfaktor des jeweiligen Multiplikatorelements (802) auf den gewünschten Wert zurückzusetzen; und
- den jeweiligen Memristor (804) der Multiplikatorelemente (802) dem ermittelten jeweiligen Rekonfigurations-Signalbetrag zu unterwerfen.

9. Programmierbare analoge Signalverarbeitungsanordnung nach einem der vorhergehenden Ansprüche, wobei der analoge Signalbus (316) umfasst
- einen ersten Signalbus, im Folgenden analoger In-Out-Bus (316.1), zum Empfangen der Abschnittseingangssignale und zu deren Weiterleitung an einen vorkonfigurierbaren Satz von Verarbeitungsabschnitten (200) und zum Empfangen der Abschnittsausgangssignale der Verarbeitungsabschnitte gemäß der Signalbuskonfiguration;
- einen zweiten Signalbus, im Folgenden Multiplikatorbus (316.2), zum Empfangen derjeweiligen verzögerten Abschnittseingangssignale und zum Weiterleiten dieser Signale an einen vorkonfigurierbaren Satz von Verarbeitungsabschnitten (200) gemäß der Signalbuskonfiguration;
- einen dritten Signalbus, im Folgenden Addiererbus (316.3), zum Empfangen der jeweiligen Multiplikatorausgangssignale und zum Weiterleiten dieser Signale an einen steuerbaren Satz von Verarbeitungsabschnitten (200) gemäß der Signalbuskonfiguration;
- einen vierten Signalbus, im Folgenden Addiererausgangsbus, zum Empfangen der jeweiligen Addiererausgangssignale und zum Weiterleiten dieser Signale an einen vorkonfigurierbaren Satz von Resampling-Elementen (212) gemäß der Signalbuskonfiguration und an einen Ausgang der Verarbeitungsanordnung (100),
wobei der analoge In-Out-Bus (316.1), der Multiplikatorbus (316.2), der Addiererbus (316.3) und der Addiererausgangsbus jeweils schaltbar mit jeder der Verarbeitungsabschnitte gemäß der Signal-Bus-Konfiguration verbindbar sind.

10. Programmierbare analoge Signalverarbeitungsanordnung nach einem der Ansprüche 5 bis 9, wobei
- das Netzwerk von Verarbeitungsabschnitten ist in identische Makrozellen (300) unterteilt, die jeweils eine Vielzahl von Verarbeitungsabschnitten (302, 304, 306) umfassen,
- die Konfigurationssteuereinheit (160) so konfiguriert ist, dass sie den Konfigurationscode zum Erzeugen jeweiliger Konfigurationssignale verwendet, die gewünschte elektrische Verbindungen zwischen den Verarbeitungsabschnitten (302, 304, 306) einer bestimmten Makrozelle (300) herstellen;
- jede der Makrozellen (300) ein zugehöriges Steuerelement (308) hat, das die den Verarbeitungsabschnitten (302, 304, 306) der gegebenen Makrozelle (300) zugeordneten Konfigurationssignale von der Konfigurationssteuereinheit (130) empfängt, zum Steuern einer Weiterleitung von
- den Konfigurationssignalen an die jeweiligen Verarbeitungsabschnitte (302, 304, 306) der jeweiligen Makrozelle (300),
- den Konfigurationstestsignalen, die mit den Verarbeitungsabschnitten (302, 304, 306) der gegebenen Makrozelle (300) verbunden sind, und von den Abschnittstestantwortsignalen in Reaktion auf die Konfigurationstestsignale von den Verarbeitungsabschnitten der gegebenen Makrozelle über den analogen Testbus (312),
- dem Taktsignal an die jeweiligen Verarbeitungsabschnitte (302, 304, 306) der gegebenen Makrozelle (300); und von den
- analogen Datensignalen zwischen den Verarbeitungselementen der Verarbeitungsabschnitte (302, 304, 306) über den analogen Signalbus (316).

11. Programmierbare analoge Signalverarbeitungsanordnung nach einem der vorhergehenden Ansprüche, die ferner eine Takterzeugungseinheit umfasst, die so konfiguriert ist, dass sie den Verarbeitungsabschnitten (200) über den Taktbus ein Paar zweiphasiger, sich nicht überlappender Taktsignalfolgen bereitstellt.

12. Programmierbare analoge Signalverarbeitungsanordnung nach einem der vorhergehenden Ansprüche, wobei
das Verzögerungselement (702) der Verarbeitungsabschnitte eine Reihe von mindestens zwei Schaltelementen (712.1, 712.2) umfasst, die das Abschnittseingangssignal empfangen, wobei jedes der Schaltelemente auch ein Steuergatter (G) aufweist, das eine jeweilige der Taktsignalfolgen (CLK) empfängt, um das Schaltelement gemäß den zwei Phasen der jeweiligen Taktsignalfolge zu öffnen und zu schließen, und wobei das Verzögerungselement (702) ferner parallele Kapazitäten (718, 720) umfasst, die jeweils in einer Signalflussrichtung hinter jedem Schaltelement (712.1, 712.2) angeordnet sind, um das verzögerte Abschnittseingangssignal hinter dem letzten Schaltelement in der Signalflussrichtung bereitzustellen.

13. Programmierbare analoge Signalverarbeitungsanordnung nach einem der Ansprüche 1 bis 10, wobei
- der analoge Signalbus mit mindestens einer Handshake-Leitung verbunden ist und von dieser gesteuert wird, um Kommunikationssteuersignale zwischen den Verarbeitungsabschnitten gemäß einem Handshake-Protokoll zu transportieren;
- die Verarbeitungsabschnitte oder, falls vorhanden, Makrozellen jeweils eine zugehörige Handshake-Schaltung (1602) umfassen, die konfiguriert ist, um
- Kommunikationssteuersignale im Namen des jeweiligen zugehörigen Verarbeitungsabschnitts oder Makrozelle für die asynchrone Kommunikation mit anderen Verarbeitungsabschnitten oder Makrozellen des Netzwerkes von Verarbeitungsabschnitten oder Makrozellen gemäß einem Handshake-Protokoll zu erzeugen und bereitzustellen;
- die Zeitverzögerung bei der Bereitstellung des verzögerten Abschnittseingangssignals durch das Verzögerungselement (1604) zu steuern, und um
- ein Timing einer Ausgabe des Multiplikatorausgangssignals oder des Addiererausgangssignals über den Signalbus in Reaktion auf einen Protokollaustausch mit mindestens einem Zielverarbeitungsabschnitts gemäß dem Handshake-Protokoll zu steuern.

## Revendications

1. Réseau de traitement analogique programmable (100) pour un traitement discret dans le temps programmable de signaux d'entrée analogiques entrants conformément à une fonction de traitement de signal souhaitée et pour fournir des signaux de sortie analogiques traités conformément à la fonction de traitement de signal, le réseau de traitement comprenant :
- un réseau (114) de tranches de traitement analogique (200) mutuellement interconnectables et préconfigurables qui forment des cellules de circuit unitaire du réseau (114) et qui comprennent chacune un ensemble d'éléments de circuit cellulaire formés par
- un port d'entrée d'horloge commutable (CLK) pour recevoir un signal d'horloge;
- un élément de retard (202) pour recevoir un signal d'entrée de tranche analogique respectif et pour transmettre le signal d'entrée de tranche reçu avec un retard temporel préconfigurable en tant que signal d'entrée de tranche retardé respectif ;
- un élément multiplicateur analogique (206) recevant le signal d'entrée de tranche retardé, pour fournir un signal de sortie multiplicateur analogique correspondant à un produit du signal d'entrée de tranche retardé avec un facteur de multiplication préconfigurable, et
- un élément additionneur analogique (210) recevant une sélection préconfigurable d'au moins deux signaux d'entrée d'additionneur comprenant le signal de sortie du multiplicateur, pour fournir un signal de sortie d'additionneur analogique correspondant à une somme des signaux d'entrée de l'additionneur ; et
- un élément de rééchantillonnage analogique (212) pour recevoir le signal de sortie de l'additionneur et pour fourni la sortie de l'additionneur reçue d'un retard préconfigurable en tant que signal de sortie de tranche analogique ;
- un bus de signaux analogiques préconfigurable (108) pour recevoir et fournir les signaux d'entrée analogiques au réseau (114) de tranches de traitement (200) et pour interconnecter n'importe quelle tranche de traitement donnée (200) à une ou plusieurs autres tranches de traitement respectives du réseau (114) de tranches de traitement (200) afin de transporter les signaux d'entrée de tranche et les signaux de sortie de tranche ;
- un bus de signaux de configuration (132) pour recevoir et acheminer des signaux de commande de configuration respectifs vers les tranches de traitement individuelles, les signaux de commande de configuration respectifs étant destinés à configurer :
- des temporisations individuelles des éléments de retard respectifs (202),
- des facteurs de multiplication individuels des éléments multiplicateurs respectifs (206),
- des sélections individuelles de signaux d'entrée d'additionneur vers les éléments additionneurs respectifs (212),
- des interconnexions commutables individuelles des tranches de traitement respectives (200) au bus de signaux analogiques (108) pour acheminer, conformément à une configuration de bus de signaux programmable et à la fonction de traitement de signal, les signaux d'entrée, les signaux d'entrée de tranche respectifs, et les signaux de sortie de tranche respectifs entre les tranches de traitement via le bus de signaux analogiques ;
- et, connecté au réseau de tranches de traitement,
- des états de commutation individuels des ports d'entrée d'horloge pour autoriser ou bloquer la fourniture du signal d'horloge aux tranches de traitement respectives ;
- une unité de commande de configuration (130) pour recevoir un code de configuration et pour utiliser le code de configuration pour générer les signaux de commande de configuration pour configurer le réseau (114) de tranches de traitement (200) pour mettre en oeuvre un circuit de traitement de signal analogique qui en fonctionnement remplit la fonction de traitement du signal souhaitée.

2. Réseau programmable de traitement de signaux analogiques selon la revendication 1, dans lequel
- l'élément de retard (202) est configuré pour recevoir le signal d'entrée de tranche analogique respectif en tant que premier signal de tension analogique et pour fournir le signal d'entrée de tranche retardé respectif en tant que deuxième signal de tension analogique,
- l'élément multiplicateur analogique (206) est configuré pour fournir le signal de sortie du multiplicateur analogique en tant que premier signal de courant analogique, et
- l'élément additionneur analogique (210) est configuré pour recevoir les au moins deux signaux d'entrée de l'additionneur sous forme de signaux de courant analogiques et pour fournir le signal de sortie de l'additionneur analogique également sous la forme d'un signal de courant analogique d'une quantité indicative de la somme des signaux d'entrée de l'additionneur, et dans lequel
- l'élément de rééchantillonnage (212) comprend un convertisseur courant-tension pour recevoir le signal de sortie de l'additionneur analogique et pour fournir comme signal de sortie de tranche un signal de tension de sortie de l'additionneur d'une quantité de tension de sortie indicative de la quantité de courant du signal de sortie de l'additionneur analogique ; et dans lequel
- un plan de tension du signal de tension de sortie de tranche du convertisseur courant-tension est le même que celui du signal d'entrée de tranche reçu par l'élément de retard (202).

3. Réseau programmable de traitement de signaux analogiques selon la revendication 1 ou 2, comprenant en outre
- un port d'entrée de configuration (126) pour recevoir des données de description de matériel définissant, à l'aide d'un langage de description de matériel, une structure et un comportement d'un circuit de traitement de signal analogique effectuant une fonction de traitement de signal et devant être mis en oeuvre par le réseau de traitement de signal analogique programmable (100) ;
- un processeur de configuration (128) pour transformer les données de description de matériel en données de liste de connectivité indicatives d'une liste de connectivité de tranches de traitement et pour transformer les données de liste de connectivité en données de placement-routage indicatives d'informations de placement-routage à être mis en oeuvre à l'aide du réseau (114) de tranches de traitement (200) et déterminer les interconnexions souhaitées des tranches de traitement (200) qui mettent en oeuvre le circuit de traitement de signal analogique, et transformer la liste de connectivité et les données de placement-routage en code de configuration.

4. Réseau programmable de traitement de signaux analogiques selon la revendication 3, dans lequel
- le processeur de configuration (128) est en outre configuré pour générer, à l'aide des données de description de matériel, des données de réponse de tranche souhaitées qui sont indicatives de signaux d'entrée de tranche retardés individuels souhaités des éléments de circuit cellulaire respectifs des tranches de traitement individuelles en réponse à un ou plusieurs des signaux de test de configuration analogique prédéterminés ;
- le réseau de traitement de signal analogique programmable (100) comprend en outre un bus de test analogique (134, 214, 312), qui est connecté à l'unité de commande de configuration (130) et qui peut être connecté aux tranches de traitement individuelles (200, 302, 304, 306) pour leur fournir le ou les signaux de test de configuration analogiques générés par l'unité de commande de configuration (130) et pour fournir à l'unité de commande de configuration (130) des signaux de réponse de test de tranche individuelle respectifs fournis par les éléments de circuit cellulaire respectifs des tranches de traitement (200), chacun en réponse au ou aux signaux de test de configuration ; où
- l'unité de commande de configuration (130) est configurée pour générer le ou les signaux de test de configuration prédéterminés et pour déterminer les écarts des signaux de réponse de test de tranche reçus par rapport aux données de réponse de tranche souhaitées conformément à des critères d'écart prédéterminés, et en cas de détermination d'un écart pour une tranche de traitement donnée (200), pour générer les données de configuration adaptées pour la tranche de traitement respective et utiliser les données de configuration adaptées pour fournir un ou plusieurs signaux de configuration adaptés à la tranche de traitement respective.

5. Réseau de traitement analogique programmable selon la revendication 3 ou la revendication 4 dans la mesure où elle dépend de la revendication 3, comprenant en outre une mémoire de configuration pour stocker la liste de connectivité, les données de placement-routage, le code de configuration, les données de configuration et les données de configuration adaptées.

6. Réseau programmable de traitement des signaux analogiques de l'une des revendications précédentes, dans lequel l'élément multiplicateur des tranches de traitement comprend un memristor configurable (804), qui reçoit le signal d'entrée de la tranche retardée et qui est configuré pour fournir le signal de sortie du multiplicateur en tant que signal de courant d'une quantité de courant qui est indicative d'un produit d'une quantité de tension d'entrée du signal d'entrée de la tranche retardée multipliée par le facteur de multiplication.

7. Réseau de traitement de signal analogique programmable selon la revendication 6, dans lequel l'unité de commande de configuration (130) est configurée
- pour utiliser les données d'entrée de configuration ou, si elles sont présentes, les données de configuration adaptées pour déterminer les quantités de signaux de configuration de memristor respectifs à appliquer au memristor respectif (804) des éléments multiplicateurs (802) des tranches de traitement individuelles pour définir un facteur de pondération respectif de la multiplication de l'élément multiplicateur respectif, et
- pour soumettre le memristor respectif (804) des éléments multiplicateurs au signal de configuration déterminé de la quantité de signal de configuration déterminée.

8. Réseau de traitement analogique programmable selon les revendications 4 et 7, dans lequel l'unité de commande de configuration (130) est configurée
- pour passer à un mode d'étalonnage en arrière-plan intermittent sous le fonctionnement du réseau de traitement (100), et, en mode d'étalonnage en arrière-plan,
- pour générer et fournir via le bus de test analogique (134, 214, 312) un ou plusieurs signaux de test multiplicateur aux éléments multiplicateurs (802),
- pour déterminer à partir des signaux de sortie du multiplicateur reçus un écart d'un facteur de multiplication respectif par rapport aux facteurs de multiplication souhaités respectifs selon le code de configuration ; et, en cas de constatation d'un écart,
- pour générer et fournir une quantité de signal de reconfiguration de memristor respectif à appliquer au memristor respectif (804) des éléments multiplicateurs (802) des tranches de traitement individuelles afin de réinitialiser le facteur de multiplication respectif de l'élément multiplicateur respectif (802) à la valeur souhaitée ; et
- pour soumettre le memristor respectif (804) des éléments multiplicateurs (802) à la quantité de signal de reconfiguration respective déterminée.

9. Réseau de traitement de signal analogique programmable selon l'une quelconque des revendications précédentes, dans lequel le bus de signal analogique (316) comprend
- un premier bus de signaux, ci-après bus d'entrée-sortie analogique (316.1), pour recevoir les signaux d'entrée de tranche et les acheminer vers un ensemble préconfigurable de tranches de traitement (200) et pour recevoir les signaux de sortie de tranche des tranches de traitement conformément avec la configuration du bus de signal ;
- un deuxième bus de signal, ci-après bus multiplicateur (316.2), pour recevoir les signaux d'entrée de tranche retardés respectifs et les acheminer vers un ensemble préconfigurable de tranches de traitement (200) conformément à la configuration du bus de signal ;
- un troisième bus de signaux, ci-après bus additionneur (316.3), pour recevoir les signaux de sortie du multiplicateur respectifs et les acheminer vers un ensemble contrôlable de tranches de traitement (200) conformément à la configuration du bus de signaux ;
- un quatrième bus de signaux, ci-après bus de sortie de l'additionneur, pour recevoir les signaux de sortie de l'additionneur respectifs et les acheminer vers un ensemble préconfigurable d'éléments de rééchantillonnage (212) conformément à la configuration du bus de signaux et vers une sortie du réseau de traitement (100),
dans lequel le bus d'entrée-sortie analogique (316.1), le bus multiplicateur (316.2), le bus additionneur (316.3) et le bus de sortie additionneur sont chacun interconnectables de manière commutable avec chacune des tranches de traitement conformément à la configuration du bus de signaux.

10. Réseau de traitement de signal analogique programmable selon l'une quelconque des revendications 5 à 9, dans lequel
- le réseau de tranches de traitement est divisé en macrocellules identiques (300) comprenant chacune une pluralité de tranches de traitement (302, 304, 306),
- l'unité de commande de configuration (160) est configurée pour utiliser le code de configuration pour générer des signaux de configuration respectifs qui établissent des connexions électriques souhaitées entre les tranches de traitement (302, 304, 306) d'une macrocellule donnée (300) ;
- chacune des macrocellules (300) possède un élément de commande associé (308) qui reçoit les signaux de configuration associés aux tranches de traitement (302, 304, 306) de la macrocellule donnée (300) de l'unité de commande de configuration (130) pour commander un routage de
- les signaux de configuration vers les tranches de traitement respectives (302, 304, 306) de la macrocellule donnée (300),
- les signaux de test de configuration associés aux tranches de traitement (302, 304, 306) de la macrocellule donnée (300) et les signaux de réponse de test de tranche en réponse aux signaux de test de configuration provenant des tranches de traitement de la macrocellule donnée via le bus de test analogique (312),
- le signal d'horloge vers les tranches de traitement respectives (302, 304, 306) de la macrocellule donnée (300) ; et
- des signaux de données analogiques entre les éléments de traitement des tranches de traitement (302, 304, 306) via le bus de signaux analogiques (316).

11. Réseau de traitement de signal analogique programmable selon l'une quelconque des revendications précédentes, comprenant en outre une unité de génération d'horloge configurée pour fournir une paire de trains de signaux d'horloge biphasés sans chevauchement aux tranches de traitement (200) via le bus d'horloge.

12. Réseau programmable de traitement de signaux analogiques selon l'une quelconque des revendications précédentes, dans lequel
l'élément de retard (702) des tranches de traitement comprend une série d'au moins deux éléments de commutation (712.1, 712.2) qui reçoivent le signal d'entrée de tranche, chacun des éléments de commutation ayant également une porte de commande (G) recevant respectivement l'un des trains de signaux d'horloge (CLK) pour ouvrir et fermer l'élément de commutation conformément aux deux phases du train de signaux d'horloge respectif, et dans lequel l'élément de retard (702) comprend en outre des capacités parallèles (718, 720) disposées respectivement derrière, dans une direction du flux de signal, chaque élément de commutation (712.1, 712.2), pour fournir le signal d'entrée de tranche retardé derrière le dernier élément de commutation dans la direction du flux de signal.

13. Réseau programmable de traitement de signaux analogiques selon l'une quelconque des revendications 1 à 10, dans lequel
- le bus de signaux analogiques est associé à et contrôlé par au moins une ligne d'établissement de liaison pour transporter des signaux de commande de communication entre les tranches de traitement conformément à un protocole d'établissement de liaison ;
- les tranches de traitement ou, le cas échéant, les macrocellules comprennent chacune en outre un circuit d'établissement de liaison associé (1602) qui est configuré pour
- générer et fournir des signaux de commande de communication au nom de la tranche de traitement ou de la macrocellule associée respective pour une communication asynchrone avec d'autres tranches de traitement ou macrocellules du réseau de tranches de traitement ou de macrocellules conformément à un protocole d'établissement de liaison ;
- commander le retard dans la fourniture du signal d'entrée de tranche retardé par l'élément de retard (1604), et pour
- commander une synchronisation d'une sortie du signal de sortie du multiplicateur, ou du signal de sortie de l'additionneur via le bus de signal en réponse à un échange de protocole avec au moins une tranche de traitement cible conformément au protocole d'établissement de liaison.
